# EUROPÄISCHE PATENTSCHRIFT

(11) **EP 2 513 986 B1**
(45) Veröffentlichungstag und Bekanntmachung des Hinweises auf die Patenterteilung: **29.07.2015**
(21) Anmeldenummer: 10787462.0
(22) Anmeldetag: 07.12.2010
(51) Int. Cl.: F01N 3/04, H01L 35/30, F28D 7/16, F28F 1/32, F01N 5/02, F28F 3/04, F28F 13/06, F28F 1/02

(54) **WÄRMETAUSCHER**
HEAT EXCHANGER
ECHANGEUR DE CHALEUR

(30) Priorität: 16.12.2009 DE 102009058676
(43) Veröffentlichungstag der Anmeldung: 24.10.2012
(73) Patentinhaber: MAHLE Behr GmbH & Co. KG, 70469 Stuttgart (DE)
(72) Erfinder: BREHM, Holger, 71729 Erdmannhausen (DE); HECKENBERGER, Thomas, 70771 Leinfelden-Echterdingen (DE); HIMMER, Thomas, 73326 Reichenbach (Deggingen) (DE); LARPENT, Stéphanie, 70199 Stuttgart (DE); PATERSON, Julie, M6P2R8 Toronto, Ontario (CA); RIEDEL, Rudolf, 75173 Pforzheim (DE)
(74) Vertreter: Grauel, Andreas
(86) Internationale Anmeldenummer: PCT/EP2010/069107
(87) Internationale Veröffentlichungsnummer: WO 2011/082922

(56) Entgegenhaltungen:
- DE-A1-102008 022 802
- JP-A- 9 036 439
- JP-A- 11 036 981
- US-A- 3 212 275
- US-A- 4 095 998
- US-A- 4 297 849
- US-A1- 2005 217 714
- US-A1- 2006 157 102
- US-A1- 2008 028 769

## Beschreibung

Die vorliegende Erfindung bezieht sich auf einen Wärmetauscher zum Austausch von Wärme zwischen zwei Medien gemäß dem Anspruch 1, wie er beispielsweise in einem Fahrzeug eingesetzt werden kann.

Die beispielsweise im Abgas eines Fahrzeugs in Form von Wärme gespeicherte Energie wird bisher ungenutzt an die Umgebung abgeführt. Um den Wirkungsgrad einer Anlage, z.B. eines Fahrzeugs, zu erhöhen und folglich den CO₂-Ausstoß im Betrieb zu senken, kann ein Thermoelektrischer Generator (TEG) implementiert werden, dessen Thermoelektrisches Modul (TEM) einen Teil der Wärme in elektrische Energie umwandelt und diese an die Anlage zurückführt. Der TEG ist ein Wärmetauscher, der mit thermoelektrisch aktivem Material bestückt ist. Wird dieses Material einer Temperaturdifferenz ausgesetzt, erzeugt der TEG elektrische Energie. Die Temperaturdifferenz entsteht im TEG dadurch, dass ein heißes Medium, z.B. Abgas, und ein kaltes Medium, z.B. ein Kühlmittel, aneinander vorbeigeführt werden. Der TEG kann mit unterschiedlichem Nutzen an beliebiger Stelle im Abgasstrang oder in der Abgasrückführung untergebracht sein.

Herkömmliche TEG sind auf Grund des erhöhten Wärmedurchgangswiderstandes zwischen thermoelektrisch aktiven Materialien und einer Wärmequelle / Wärmesenke wenig effizient. Auch hat sich eine Einbindung des TEM in einen Wärmetauscher als wenig praktikabel erwiesen. Bislang verfügbare Verbindungstechniken sind teilweise nicht hochtemperaturstabil. Zudem besteht häufig auf der gasseitigen Kontaktierung des TEM Im Wärmetauscher lediglich ein geringer Wärmeübergang. Gemäß dem Stand der Technik sind demnach herkömmliche TEM auf Grund ihrer Gestaltung und Verbindungstechnik nicht optimal für den Einsatz in einem TEG geeignet und auch weniger effektiv.

Die EP 1 475 532 A2 offenbart einen thermoelektrischen Generator mit einem thermoelektrischen Element, das Abgas von einem Motor als eine Hochtemperatur-Wärmequelle und ein Motorkühlmittel als eine Niedertemperatur-Wärmequelle zur Erzeugung von Elektrizität nutzt, Ein Ventil regelt die Zuführung des Abgases zu dem thermoelektrischen Element entsprechend der Motorlast.

Die US 2008/0028769 A1 offenbart ein Rohr mit einem thermoelektrischen Element, wobei außerhalb des thermoelektrischen Elements eine Übertragungsfläche mit Rippen angeordnet ist. Auch die US 4 095 998 offenbart eine solche Struktur. Auch die JP 11036981 und die JP 09036439 offenbaren solche Rohrstrukturen.

Es ist die Aufgabe der vorliegenden Erfindung, einen verbesserten Wärmetauscher zum Austausch von Wärme zwischen zwei Medien zu schaffen.

Diese Aufgabe wird durch einen Wärmetauscher gemäß Anspruch 1 gelöst.

Der vorliegenden Erfindung liegt die Erkenntnis zugrunde, dass mit einem Aufbau eines Wärmetauschers, insbesondere als Kreuzströmer, eine Optimierung des thermoelektrischen Generators erzielt werden kann. Alternativ zu der Erzeugung elektrischer Energie aus Wärmeenergie kann der erfindungsgemäße Wärmetauscher auch als thermoelektrischer Heizer und Kühler Verwendung finden.

Die vorliegende Erfindung schafft einen Wärmetauscher zum Austausch von Wärme zwischen zwei Medien in einem Fahrzeug, wobei der Wärmetauscher folgende Merkmale aufweist: Zumindest ein Rohr, insbesondere ein doppelwandiges Rohr zum Führen oder Leiten eines ersten Mediums mit einer ersten Temperatur, wobei ein thermoelektrisches Material zwischen einer Innenwand des Rohres und einer Außenwand des Rohres oder zumindest an einer Innenwand des Rohres angeordnet ist; und zumindest ein mit dem mindestens einen Rohr verbundenes Führungsblech zum Führen eines zweiten Mediums mit einer zweiten Temperatur, wobei das zumindest eine Führungsblech ausgebildet ist, um das zweite Medium an die Außenwand des zumindest einen Rohres zu führen, um den Austausch von Wärme zwischen dem ersten und zweiten Medium zu ermöglichen.

Bei dem Wärmetauscher kann es sich um einen thermoelektrischen Generator zur Erzeugung von elektrischem Strom aus einer Temperaturdifferenz zwischen zwei Medien handeln. Alternativ kann es sich bei dem Wärmetauscher auch um einen thermoelektrischen Heizer bzw. Kühler handeln, der unter Verwendung von elektrischem Strom eine Heiz- bzw. Kühlleistung bereitstellt. Ein derartiger Wärmetauscher kann beispielsweise in Fahrzeugen eingesetzt werden. Bei einem Einsatz des erfindungsgemäßen Wärmetauschers als thermoelektrischer Generator kann zum Beispiel ein Kühlmittel zur Kühlung des Motors oder der Batterie des Fahrzeugs als das erste Medium und ein von einem Verbrennungsmotor des Fahrzeugs erzeugtes Abgas als das zweite Medium Verwendung finden. Das Rohr kann zum Beispiel als ein Flachrohr oder ein Rundrohr ausgebildet sein. Zudem kann das Rohr als ein einwandiges oder doppelwandiges Rohr ausgeführt sein. Dabei wird das doppelwandige Rohr im Allgemeinen von einem Innenrohr und einem das Innenrohr umschließenden Außenrohr gebildet. In diesem Fall ist das thermoelektrische Material zwischen dem Innenrohr und dem Außenrohr angeordnet. Bei dem Führungsblech kann es sich um einen Blechstreifen handeln, entlang dem zum Beispiel das Abgas aus dem Verbrennungsmotor geführt werden kann. Der erfindungsgemäße Wärmetauscher kann eine Mehrzahl von schichtweise angeordneten Führungsblechen und eine Mehrzahl von parallel angeordneten Rohren aufweisen. Dabei kann beispielsweise jedes der Führungsbleche Öffnungen aufweisen, durch die die Mehrzahl von Rohren derart aufgenommen und gehalten ist, dass die Rohre und Führungsbleche im Wesentlichen orthogonal zueinander angeordnet sind. Entsprechend können das erste und das zweite Medium im Kreuzstrom geführt werden, ohne dass eine Durchmischung beider Medien stattfindet. Dabei kann im Allgemeinen das erste Medium innerhalb des Rohres (beilspielsweise in einem Innenrohr eines doppelwandigen Rohres) und das zweite Medium zwischen Hauptflächen der Führungsbleche und um die Außenwände der Rohre herum geführt werden. Alternativ kann auch das zweite Medium innerhalb des mindestens einen Rohres und das erste Medium entlang des mindestens einen Führungsblechs geführt werden. Bei dem thermoelektrischen Material kann es sich beispielsweise um unterschiedlich dotierte Halbleitermaterialien handeln. Entsprechend dem Aufbau des hier vorgeschlagenen Wärmetauschers ist das thermoelektrische Material zwischen den günstigerweise kreuzweise strömenden Medien mit unterschiedlichen Temperaturen so angeordnet, dass es beiden Medien gleichmäßig ausgesetzt ist, dass also ein Temperaturgradient über den gesamten Wärmetauscher möglichst homogen und gering ist.

Gemäß einer Ausführungsform kann das Führungsblech zumindest eine Aussparung aufweisen. Das Rohr kann von der Aussparung aufgenommen sein. Entsprechend einem derartigen Aufbau von Führungsblech und Rohr kann eine Strömungsrichtung des ersten Mediums von einer Strömungsrichtung des zweiten Mediums abweichen. Beispielsweise kann das erste Medium im Wesentlichen orthogonal zu dem zweiten Medium strömen. Ein derartiges Strömungsverhältnis ermöglicht einen besseren Wärmeübergang zwischen dem ersten und dem zweiten Medium, als dies z.B. bei einem Gleichstrom (d.h. einem Strom in gleiche Richtung) der beiden Medien der Fall wäre. Das Führungsblech kann auch eine Mehrzahl von Aussparungen zum Aufnehmen von mehreren Rohren aufweisen, wobei dann jedes Rohr in einer eigenen Aussparung aufgenommen werden kann.

Gemäß einer weiteren Ausführungsform kann zumindest ein weiteres, insbesondere doppelwandiges Rohr im Wesentlichen parallel zu dem Rohr in einer gemeinsamen ersten Ebene und zumindest ein drittes, insbesondere doppelwandiges Rohr in einer zu der ersten Ebene parallelen zweiten Ebene angeordnet sein. Dabei kann das dritte Rohr in der zweiten Ebene in einer Position angeordnet sein, an der in der ersten Ebene ein Durchgang zwischen dem Rohr und dem weiteren Rohr gebildet ist: Aus einer derartigen nicht fluchtenden Anordnung von mehreren Rohren ergibt sich ein mäandernder Strömungsfluss des zweiten Mediums um die Rohre, was die Wärmeübergangsfläche zwischen beiden Medien vorteilhaft vergrößert.

Auch kann die Innenwand des Rohres einen Führungskanal für das erste Medium bilden, wobei die Innenwand ferner Ausbuchtungen in den Führungskanal aufweisen kann, Zusätzlich oder alternativ kann die Außenwand des Rohres ferner Erhebungen in Richtung eines Flussbereiches für das zweite Medium aufweisen. Sowohl die Ausbuchtungen als auch die Erhebungen können als gefüllte oder ungefüllte Noppen ausgebildet sein, die unterschiedliche Formen aufweisen können. Die Ausbuchtungen und/oder Erhebungen können wie eine Turbulenzeinlage wirken, um beilspielsweise ein Verwirbeln eines flüssigen Mediums zu bewirken. Ferner weisen die Ausbuchtungen und/oder Erhebungen den Vorteil auf, dass sie eine Wärmeübergangsfläche für das erste und/oder das zweite Medium vergrößern können, wodurch der Wärmeübergangskoeffizient verbessert werden kann.

Gemäß einer weiteren Ausführungsform kann das Führungsblech eine Profilierung aufweisen. Beilspielsweise kann die Profilierung in Form einer Mehrzahl von gefüllten oder ungefüllten Noppen auf einer Oberfläche des Führungsblechs ausgebildet sein. Die Noppen können unterschiedliche Geometrien aufweisen. Die Profilierung kann als ein Abstandshalter zwischen dem Führungsblech und einem benachbarten Führungsblech dienen.

Die Profilierung kann in Form von einer Mehrzahl von länglichen Erhebungen ausgebildet sein. Dabei kann die Mehrzahl von Erhebungen derart auf dem Führungsblech angeordnet sein, dass eine mäanderförmige Führung für das zweite Medium um mehrere Rohre ermöglicht wird. Beispielsweise können die länglichen Erhebungen als schmale längliche Noppen zwischen zwei sich diagonal gegenüberliegenden Rohren aus zwei unterschiedlichen Reihen parallel fluchtend angeordneter Rohre ausgebildet sein. Auf diese Weise kann das zweite Medium vorteilhaft entlang der Außenwand des Rohres geführt bzw. umgelenkt werden, wodurch ein besserer Wärmeübergang mit dem in dem Innenrohr geführten ersten Medium erzielt werden kann.

Gemäß einer weiteren Ausführungsform kann das Führungsblech eine Profilierung in Form einer Mehrzahl von Ausbuchtungen aufweisen. Das Führungsblech kann zu mindestens einem weiteren Führungsblech mit einer Profilierung in Form einer Mehrzahl von Ausbuchtungen benachbart angeordnet sein, wobei mehrere Ausbuchtungen der Profilierung des Führungsbleches rückseitig in entsprechende Ausbuchtungen der Profilierung des weiteren Führungsblechs eingreifen können. So kann auf günstige Weise eine Fixierung mehrerer stapelartig angeordneter Führungsbleche untereinander und damit auch eine verbesserte Halterung für mehrere Rohre, die den Stapel von Führungsblechen durchgreift, geschaffen werden.

Alternativ kann das Führungsblech zu mindestens einem weiteren Führungsblech mit einer Profilierung benachbart angeordnet sein, wobei die Profilierung des Führungsblechs und die Profilierung des weiteren Führungsblechs die gleiche Struktur aufweisen und in eine gleiche Erhebungsrichtung weisen können, wobei aber das weitere Führungsblech um 180° in Bezug auf eine Normale zum Führungsblech gedreht sein kann. Gemäß dieser Ausführungsform kann also verhindert werden, dass die Profilierungen zweier benachbarter Führungsbleche mit identischer Profilierung ineinander greifen, da auf diese Weise beispielsweise ein Abstand zwischen den Führungsblechen für bestimmte Verwendungszwecke oder Einsatzszenarien des Wärmetauschers zu gering wäre. Da auf eine Herstellung verschiedenprofiliger Führungsbleche verzichtet werden kann, können jedoch auf eine solche Anordnungsart der Führungsbleche Produktionskosten gespart werden, da lediglich gleichartige Führungsbleche hergestellt werden mussten.

Auch kann das Führungsblech zu mindestens einem weiteren Führungsblech mit einer Profilierung benachbart angeordnet sein, wobei die Profilierung des Führungsblechs und die Profilierung des weiteren Führungsblechs einander zugewandt sein können. Bei einem Stapel aus Führungsblechen können also abwechselnd je zwei Oberseiten mit Profilierung und je zwei Oberseiten ohne Profilierung einander zugewandt sein. Dies bietet den Vorteil, dass die Profilierungserhebungen der beiden Führungsbleche sich gegenseitig berühren und dadurch ein größerer Abstand der beiden Führungsbleche voneinander sichergestellt werden kann. Für einige Einsatzszenanen, insbesondere für zweite Medien mit höherer Viskosität ist ein solcher größerer Abstand der Führungsbleche möglicherweise hilfreich, um einen geringeren Strömungswiderstand des zweiten Mediums zwischen den Führungsblechen sicherzustellen.

Gemäß einer weiteren Ausführungsform kann das mindestens eine Führungsblech im Bereich der Durchführungen des Rohres uneben sein oder im Bereich der mindestens einen Aussparung uneben sein. Beispielsweise kann das Führungsblech im Bereich der Aussparungen gewellt sein. Diese Ausführungsform des Führungsbleches bietet zum einen den Vorteil, dass eine verbesserte Halterung für das mindestens eine Rohr ohne zusätzliche Bauteile erzielt werden kann, da aufgrund der unebenen Form ein größerer Bereich des Rohres durch das Führungsblech kontaktiert und gehalten wird. Zum anderen kann ein verbesserter Wärmeübergang zwischen dem Führungsblech und dem Rohr ermöglicht werden, da eine größere Kontaktlinie zwischen dem unebenen Führungsblech und dem Rohr besteht.

Vorteilhafte Ausführungsbeispiele der vorliegende Erfindung werden nachfolgend Bezug nehmend auf die beiligenden Zeichnungen näher erläutert. Es zeigen:
- Fig. 1: eine isometrische. Darstellung eines Wärmetauschers gemäß einem Ausführungsbeispiel der vorliegenden Erfindung;
- Fig. 2: eine isometrischen Darstellung des erfindungsgemäßen Wärmetauschers aus Fig. 1 im Längsschnitt;
- Fig. 3 bis 5: isometrische Darstellungen von TEM-Rohren gemäß Ausführungsbeispielen der vorliegenden Erfindung;
- Fig. 6: eine isometrische Darstellung eines Wärmetauschers im Längsschnitt, gemäß einem weiteren Ausführungsbeispiel der vorliegenden Erfindung;
- Fig. 7: eine Darstellung einer fluchtenden Anordnung von TEM-Rohren im Querschnitt, gemäß einem Ausführungsbeispiel der vorliegenden Erfindung;
- Fig. 8: eine Garstellung einer versetzten Anordnung von TEM-Rohren im Querschnitt, gemäß einem Ausführungsbeispiel der vorliegenden Erfindung;
- Fig. 9: isometrische Darstellungen von zwei unterschiedlich ausgeformten Böden für einen erfindungsgemäßen TEG, gemäß Ausführungsbeispielen der vorliegenden Erfindung;
- Fig. 10: eine isometrische Darstellung eines Gehäuses für einen erfindungsgemäßen TEG, gemäß einem Ausführungsbeispiel der vorliegenden Erfindung;
- Fig. 11: isometrische Darstellungen von zwei unterschiedlich ausgeformten Diffusoren für einen erfindungsgemäßen TEG, gemäß Ausführungsbeispielen der vorliegenden Erfindung,
- Fig. 12: isometrische Darstellungen im Schnitt von zwei unterschiedlichen erfindungsgemäßen Ausführungen von TEG-Blöcken mit Biechstreifen-Berippung;
- Fig. 13: eine Darstellung von zwei unterschiedlich ausgeformten Blechstreifen als Führungsblechen in Draufsicht, gemäß Ausführungsbeispielen der vorliegenden Erfindung;
- Fig. 14 bis 19: Darstellungen von Blechstreifen als Führungsblechen mit unterschiedlichen Profilierungsgeometrien in Draufsicht, gemäß Ausführungsbeispielen der vorliegenden Erfindung;
- Fig. 20: eine Darstellung eines TEG mit profilierten Blechstreifen als Führungsblechen im Querschnitt, gemäß einem Ausführungsbeispiel der vorliegenden Erfindung;
- Fig. 21: die Schnittansicht des TEG aus Fig. 20 mit einer Prinzipdarstellung einer Strömungsführung für ein Medium, gemäß einem Ausführungsbeispiel der vorliegenden Erfindung;
- Fig. 22: eine Garstellung eines TEG mit profilierten Blechstreifen als Führungsblechen im Querschnitt, gemäß einem weiteren Ausführungsbeispiel der vorliegenden Erfindung;
- Fig. 23: die Schnittansicht des TEG aus Fig. 22 mit einer Prinzipdarstellung einer Strömungsführung für ein Medium, gemäß einem weiteren Ausführungsbeispiel der vorliegenden Erfindung;
- Fig. 24 bis 26: Darstellungen im Querschnitt von TEGs mit unterschiedlichen Rohrbündel-Anordnungen bzw. Gehäusegeometrien, gemäß Ausführungsbeispielen der vorliegenden Erfindung;
- Fig. 27: eine Darstellung eines Blechstreifen-Stapels als Führungsbleche mit Profilierung in Seitenansicht, gemäß einem Ausführungsbeispiel der vorliegenden Erfindung;
- Fig. 28: eine Darstellung eines Blechstreifen-Stapels als Führungsbleche mit ineinandergesteckter Profilierung in Seitenansicht, gemäß einem Ausführungsbeispiel der vorliegenden Erfindung;
- Fig. 29: eine isometrische Prinzipdarstellung für eine Anordnung eines Blechstreifen-Stapels als Führungsbleche mit Profilierung, gemäß einem Ausführungsbeispiel der vorliegenden Erfindung;
- Fig. 30: eine Darstellung eines Blechstreifen-Stapels als Führungsbleche mit Profilierung in einer Seitenansicht, gemäß einem weiteren Ausführungsbeispiel der vorliegenden Erfindung;
- Fig. 31: eine isometrische Darstellung eines unebenen Blechstreifens als Führungsblech mit Profilierung, gemäß einem Ausführungsbeispiel der vorliegenden Erfindung;
- Fig. 32: eine Darstellung in Seitenansicht eines Stapels aus einer Mehrzahl von unebenen Blechstreifen gemäß dem Ausführungsbeispiel aus Fig. 28;
- Fig. 33: eine isometrische Darstellung einer Ausführung des erfindungsgemäßen Wärmetauschers als thermoelektrischer Heizer bzw. Kühler;
- Fig. 34: eine isometrische Darstellung des erfindungsgemäßen thermoelektrischen Heizers bzw. Kühlers aus Fig. 33 im Längsschnitt;
- Fig. 35: eine isometrische Darstellung eines thermoelektrischen Heizers bzw. Kühlers, gemäß einem weiteren Ausführungsbeispiel der vorliegenden Erfindung; und
- Fig. 36: eine isometrische Darstellung eines Blechstreifens als Führungsblech für eine Ausführung des erfindungsgemäßen Wärmetauschers als ein Parallelströmer, gemäß einem Ausführungsbeispiel der vorliegenden Erfindung.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.

Der erfindungsgemäße Wärmetauscher kann beispielsweise als ein thermoelektrischer Generator (TEG) zur Stromgewinnung in einem Fahrzeug eingesetzt werden.

In einem TEG gemäß Ausführungsbeispielen der Erfindung können im KreuzStrom zwei Medien mit unterschiedlicher Temperatur entlang einer Wärmeübertragungsstrecke aneinander vorbeigeführt werden, so dass es zu einem Wärmetransport vom warmen zum kalten Medium kommen kann. Die beiden Medien sind getrennt, so dass es zu keiner Durchmischung kommt. Beim heißen Medium handelt es sich beispielsweise um Abgas, beim kalten Medium beispielsweise um ein Wasser-Glysantin-Gemisch, das als Kühlmittel eingesetzt werden kann. Das Abgas entstammt beispielsweise einem Verbrennungsmotor, das Wasser-Glysantin-Gemisch einem Kühlmittelkreislauf zur Kühlung verschiedener Motor-, Klimaanlagen-, oder Batteriekomponenten.

Der TEG kann beispielsweise im Wesentlichen aus folgenden Komponenten zusammengesetzt sein: Eventuell einer Halterung, einem thermoelektrischen Modul (TEM), zumindest einer Profilierung, zumindest einem Boden, einem Gehäuse, aus Diffusoren oder Sammlern sowie eventuell einer Turbulenzeinlage.

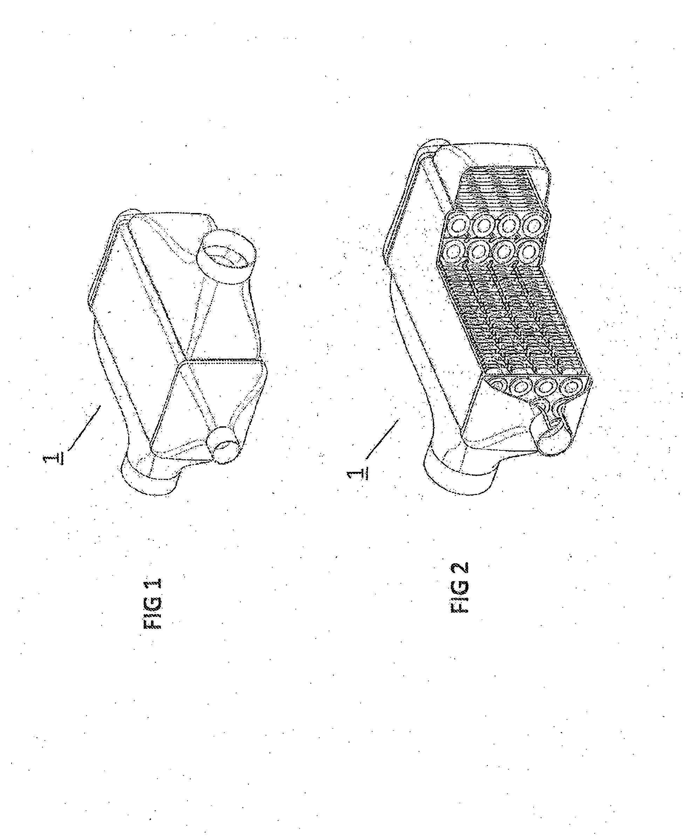

Fig. 1 zeigt in einer isometrischen Darstellung eine Außenansicht eines Wärmetauschers 1 als TEG gemäß einem Ausführungsbeispiel der vorliegenden Erfindung.
Fig. 2 zeigt ein Ausführungsbeispiel des erfindungsgemäßen TEG 1 aus Fig. 1 im axialen Längsschnitt. Seine Bauform stellt aus konstruktiver, thermodynamischer Sicht einen Kreuzstrom-Rohrbündel-Wärmetauscher 1 dar, welcher von zwei Medien unterschiedlicher Temperatur durchströmt werden kann, ohne dass sich die Medien dabei durchmischen.

Entsprechend dem hier vorgestellten Ansatz ist an einer Innenseite der Mehrzahl von Rohren des Wärmetauschers ein thermoelektrisches Material angeordnet, das das thermoelektrische Modul (TEM) des Wärmetauschers bildet. Bei einem Einsatz des Wärmetauschers als TEG dient das TEM zur Stromgewinnung aus Abgaswärme.

Beispielsweise liegt an dem hier dargestellten TEM außerhalb auf einer Seite eine Wärmequelle anhand eines zweiten Mediums und auf der anderen Seite eine Wärmesenke anhand eines ersten Mediums an, so dass es auf Grund der unterschiedlichen Temperaturen der beiden Medien zu einem Wärmetransport von der warmen zur kalten Seite kommt. Infolge produziert das TEM gemäß dem Seebeck-Effekt bei anliegender Temperaturdifferenz Strom.

Das TEM ist im Allgemeinen so aufgebaut, dass abwechselnd eine Vielzahl thermoelektrisch aktiver Materialien, z.B. n- und p-dotierte Halbleiter, über elektrische Leiter miteinander verschaltet sind. Die geometrische Ausrichtung der thermoelektrisch aktiven Materialien weist in Richtung dem Wärmestrom von der Warm- zur Kaltseite. Als Werkstoff der thermoelektrisch aktiven Materialien kommt beilspielsweise PbTe, BiTe, SiFe, SiMn oder SiMg in Frage.

Günstigerweise stellt die Trennebene bzw. -fläche zwischen heißer und kalter Seite das TEM dar. Das bedeutet, dass eine Seite des TEM in direktem oder indirektem Kontakt zu einer heißen Quelle steht, und die andere in direktem oder indirektem Kontakt zu einem halten Bereich. Die hierdurch anstehende Temperaturdifferenz zwischen der einen und anderen Seite des TEM ruft Thermodiffusionsströme innerhalb der thermoelektrisch aktiven (TE-aktiven) Materialien in dem TEM hervor, wodurch eine elektrische Spannung entsteht. Dieses Phänomen ist als Seebeck-Effekt bekannt. TE-aktive Materialien können z.B. Halbleiter-Materialien sein. Die elektrische Spannung kann in Form von elektrischem Strom abgegriffen werden. Hierzu wird der elektrische Strom über Elektro-Leitungen, die an das TEM führen und dort angeschlossen sind, einem elektrischen Verbraucher oder einem elektrischen Speicher außerhalb des TEM zugeführt.

Die TE-aktiven Materialen berühren sich gegenseitig nicht, weshalb ein Zwischenraum zwischen den TE-aktiven Materialien besteht Grundsätzlich sollte aus Effizienzgründen ein Verhältnis eines Volumens TE-aktiver Materialien zu einem Volumen des Zwischenraums möglichst groß sein.

Um die gewünschten elektrischen Spannungen und Stromflüsse einzustellen, können die in das TEM integrierten Halbleiter-Leitermaterialen gleich- oder parallelverschaltet sein. Dies gilt auch für eine elektrische Verschaltung mehrere TEM untereinander.

Das TEM bzw.. der TEG -Konstruktion kann so ausgeführt sein, dass das TEM mediendichtausgebildet ist. Daher gelangt weder das erste Medium noch das zweite Medium in das Innere des TEM und somit an die TE-aktiven Materialien.

Im Verlauf der folgenden Beschreibung wird die Bezeichnung TEM-Rohre für die Rohre des hier vorgestellten Wärmetauschers verwendet.

Das TEM bzw. das TEM-Rohr kann hinsichtlich seiner inneren und äußeren Form auf unterschiedliche Weise gestaltet sein.

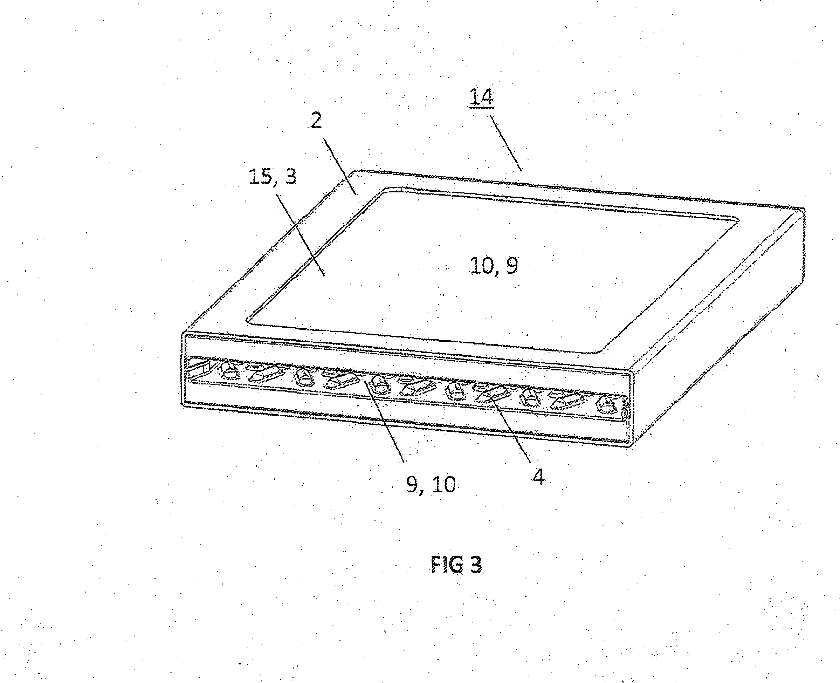

Entsprechend zeigen Figuren 3 bis 5 isometrische Darstellungen von unterschiedlich ausgebildeten TEM-Rohren, emäß Ausführungsbeispielen der vorliegenden Erfindung.

Fig. 3 zeigt in isometrischer Darstellung ein planares TEM-Rohr 14, Das planare TEM-Rohr umfasst ein Rechteckrohr 2 sowie zwei thermoelektrische Module 3. Das Rechteckrohr 2 ist gemäß diesem Ausführungsbeispiel als eine Halterung ausbildet, die an ihren gegenüberliegenden Hauptseiten Aussparungen aufweist. Die TEM 3 sind hier als planare TEM 15 ausgeführt und sind in die Halterung 2 eingefassi und mit dieser mediendicht verbunden. Die TEM 15 sind dabei parallel zueinander angeordnet. Innerhalb des Halters 2 und damit zwischen den TEM 15 strömt eines des ersten und zweiten Mediums 9, 10, außerhalb des Halters 2 strömt das andere des ersten und zweiten Mediums 10, 9. Die TEM 15 sind beiden Medien 9, 10 direkt ausgesetzt. Auf einander zugewandten Seiten der TEM 15 weist zumindest eine Oberfläche jedes der beiden TEM 15 eine Profillerung 4 auf. Der Halter 2 und die TEM 15 separieren die Medienströme 9, 10. Der Halter 2 und die TEM 3, 15 bilden eine flachrohrähnliche Einheit und werden in Kombination auch als TEM-Rohr 14 bezeichnet.

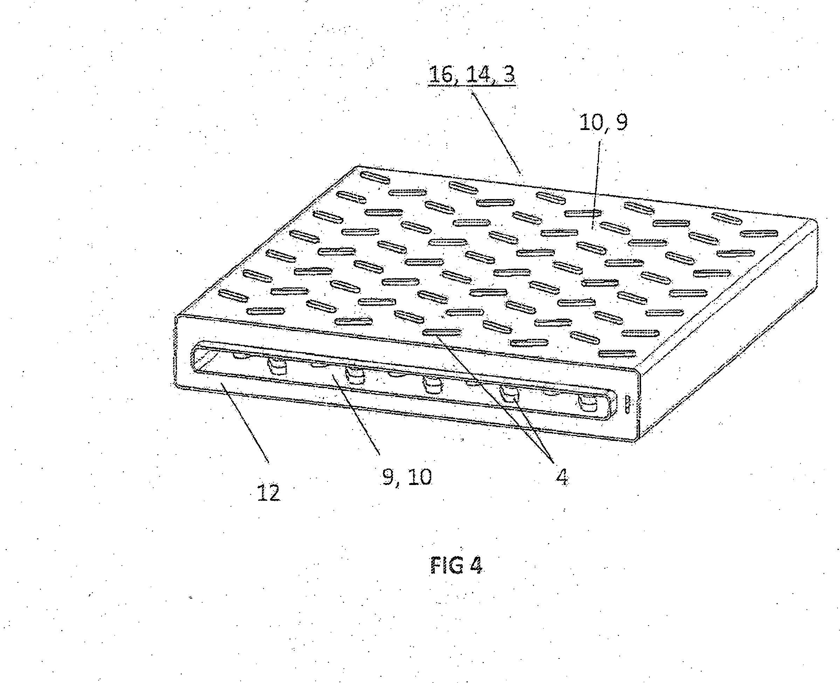

Fig. 4 zeigt ein weiteres Beispiel für eine Formgebung des TEM-Rohres 14 in einer isometrischen Darstellung. Das erfindungsgemäße TEM-Rohr 14 ist durch ein zweiwandiges Rechteck-Rohr 16 gebildet, wobei TE-aktive Materialien 12 im Zwischenraum der beiden Wandungen als thermoelektrisches Modul 3 eingebracht sind. Die innere der beiden Wandungen des TEM-Rohrs 16 steht in Kontakt mit einem der beiden Medien 9, 10, die äußere der beiden Wandungen des TEM-Rohrs 16 steht in Kontakt mit dem anderen der beiden Medien 9, 10. Beispielsweise kann die innere der beiden Wandungen des TEM-Rohrs 16 das erste Medium 9 kontaktieren, und die äußere der beiden Wandungen des TEM-Rohrs 16 das zweite Medium 10 kontaktierten. Bei dem ersten Medium 9 kann es sich um ein Kühlmittel aus einem Kühlmittelkreislauf des Fahrzeugs handeln, und bei dem zweiten Medium 10 kann es sich um ein Abgas von einem Verbrennungsmotor des Fahrzeugs handeln. Bei dem in Fig. 4 gezeigten Ausführungsbeispiel weisen die jeweiligen medienseitigen Oberfächen der inneren und der äußeren Wandung des Rechteck-Rohres 16 eine Profilierung 4 auf.

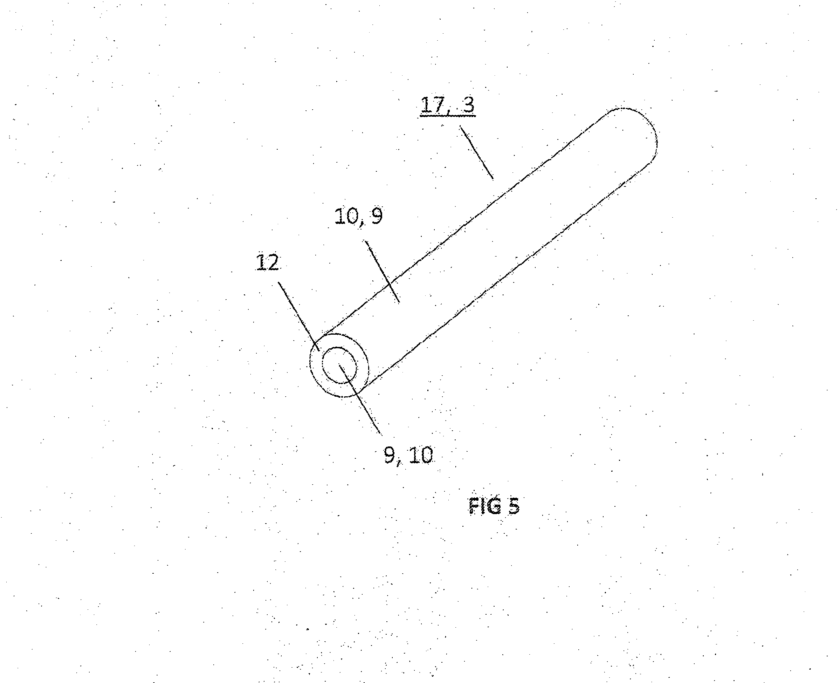

Fig. 5 zeigt eine isometrische Darstellung eines TEM-Rohres in Form eines Rund-Rohr-TEMs 17. Das TEM-Rohr wird durch ein zweiwandiges Rund-Rohr 17 gebildet, wobei TE-aktive Materialien 12 im Zwischenraum der beiden Wandungen als TEM 3 eingebracht sind. Die innere der beiden Wandungen des TEM-Rohres 17 steht in Kontakt mit einem der beiden Medien 9, 10, die äußere der beiden Wandungen des TEM-Rohrs 17 steht in Kontakt mit dem anderen Medium 9, 10. Beispielsweise kann die innere der beiden Wandungen des TEM-Rohrs 16 das erste Medium 9 kontaktieren und die äußere der beiden Wandungen des TEM-Rohrs 16 das zweite Medium 10 kontaktieren. Bei dem ersten Medium 9 kann es sich um ein Kühlmittel aus einem Kühlmittelkreislauf des Fahrzeugs handeln, und bei dem zweiten Medium 10 kann es sich um ein Abgas von einem Verbrennungsmotor des Fahrzeugs handeln.

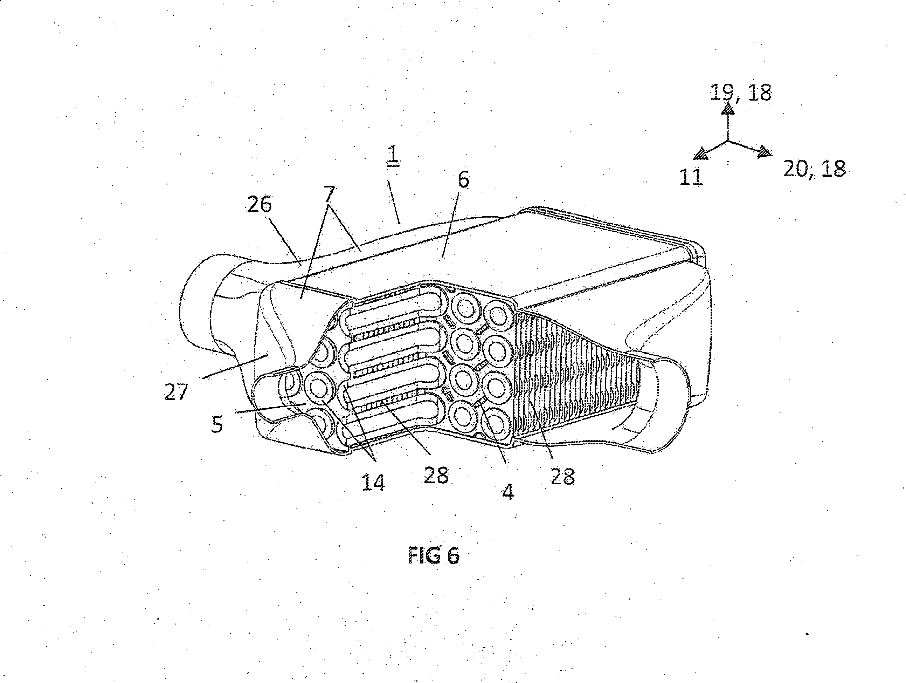

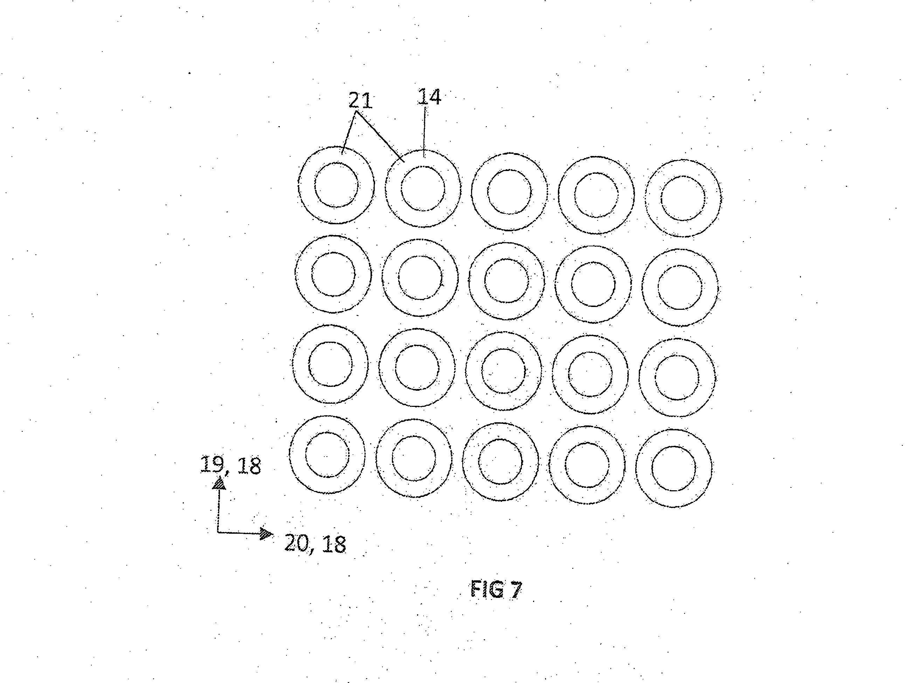

Fig. 6 zeigt in einer isometrischen Darstellung einen Aufbau des TEG 1 im Längsschnitt, gemäß einem weiteren Ausführungsbeispiel der vorliegenden Erfindung Gezeigt ist eine Profilierung 4, ein Boden 5, ein Gehäuse 6, TEM-Rohre 14, ein radialer Diffusor 7, 26, ein axialer Diffusor 7, 27 sowie ein Führungsblech bzw. Blechstreifen 28. Ein Pfeilsystem 11; 19, 18; 20, 18 kennzeichnet die drei Dimensionen des Raumes zur Veranschaulichung der isometrischen Darstellung. Dabei kennzeichnet, von einem Betrachter der Darstellung aus gesehen, 11 eine axiale Richtung, 18 eine radiale Richtung, 19 eine vertikale Richtung und 20 eine horizontale Richtung. Entsprechende Dimensionskennzeichnungen finden sich auch in den in späteren Abschnitten beschriebenen Figuren 7, 8, 10, 12, 24, 25 und 26.

Bei dem in Fig. 6 gezeigten Ausführungsbeispiel sind die TEM-Rohre 14 in dem TEG 1 übereinander, entsprechend der Dimension 18, 19, und/oder nebeneinander, entsprechend der Dimension 18, 20, gleich einem Rohrbündel angeordnet und berühren sich gegenseitig nicht. Innerhalb der TEM-Rohre 14 strömt eines der beiden Medien 9, 10, außerhalb der TEM-Rohre 14 und somit zwischen den einzelnen Lagen und Kolumnen von TEM-Rohren 14, strömt das andere Medium, In den TEM-Rohren 14 sind die TEM angeordnet. Die TEM-Rohre 14 können innen- wie außenseitig eine Profilierung bzw. Berippung 4 aufweisen, um den Wärmeübergang zu erhöhen. In Fig. 6 ist dies allerdings nicht gezeigt. Ferner kann zur Erhöhung des Wärmeübergangs auch eine Turbulenzeinlage vorgesehen sein, die ebenfalls in Fig. 6 nicht gezeigt ist. In Fig. 6 ist eine Profilierung 4 der Führungsbleche 28 in Form länglicher Erhebungen bzw. Noppen 4 gezeigt. Der Übersichtlichkeit halber ist hier lediglich eine der Erhebungen bzw. Noppen 4 auf einem der Blechstreifen 28 mit einem Bezugszeichen versehen.

Sowohl das erste Medium als auch das zweite Medium können sowohl auf der Innenseite als auch auf der Außenseite der TEM-Rohre 14 geführt werden. Das erste und das zweite Medium stehen nicht in direktem Kontakt zueinander und eine Durchmischung findet nicht statt. Die TEM-Rohre 14 trennen folglich die beiden Stoffströme des ersten und zweiten Mediums entlang einer Wärmeübertragungsstrecke, also in radialer. Richtung 18. Eine Länge der TEM-Rohre 14 in axialer Richtung 11 entspricht der Wärmeübertragungsstrecke im TEG 1. Ein Anfang und ein Ende der TEM-Rohre 14 stellt den Ein- und Austritt des ersten oder zweiten Mediums in die Wärmeübertragungsstrecke innerhalb des TEM-Rohres 14 dar.

Der erfindungsgemäße TEG 1 kann vier Diffusoren 7 aufweisen, über die er mit gas- und kühlmittelseitigen Anschlüssen kommunizieren kann. Beispielsweise wirkt ein erster radialer Diffusor 26 als ein Eintritt für Abgas, ein dem ersten radialen Diffusor gegenüberliegender weiterer radialer Diffusor 26 als ein Austritt für das Abgas, ein erster axialer Diffuser 27 als ein Eintritt für ein Kühlmittel und ein dem ersten axialen Diffusor gegenüberliegender weiterer axialer Diffusor 27als ein Austritt für das Kühlmittel.

Fig. 7 zeigt eine fluchtende Anordnung 21 von TEM-Rohren 14 im Querschnitt, gemäß einem Ausführungsbeispiel der vorliegenden Erfindung. Die TEM-Rohre 14 können in beliebiger Anzahl übereinander also in vertikaler Richtung 19, geschichtet sein. Die TEM-Rohre 14 können ebenfalls in beliebiger Anzahl nebeneinander, also in horizontaler Richtung 20, angeordnet sein. Bei der fluchtenden Anordnung 21 von TEM-Rohren 14 liegt Sowohl in vertikaler Richtung 19 als auch in horizontaler Richtung 20 ein Durchgang zwischen den jeweiligen Reihen von TEM-Rohren 14 vor.

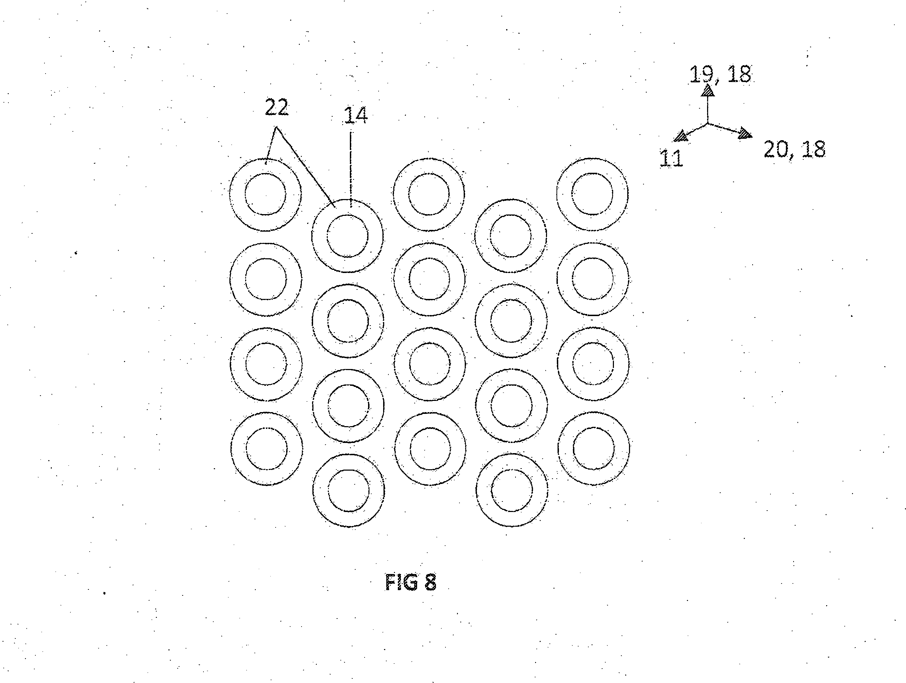

Fig. 8 zeigt eine versetzte Anordnung 22 von TEM-Rohren 14 im Querschnitt, gemäß einem weiteren Ausführungsbeispiel der vorliegenden Erfindung. Es ist zu erkennen, dass bei benachbarten vertikalen Reihen von TEM-Rohren 14 stets ein Rohr 14 aus einer Reihe vor einem Durchgang zwischen zwei Rohren einer benachbarten Reihe angeordnet ist.

Auf Oberfläche der in den Figuren 7 und 8 gezeigten TEM-Rohre 14 können noppenartige, hervorstehende Gebilde eingeprägt sein, die eine gegenseitige Abstützung der TEM-Rohre 14 untereinander gewährleisten können. An diesen Stellen kann somit ein Kontakt zwischen den TEM-Rohren 14 bestehen. Derartige Gebilde sind in den Figuren 7 und 8 jedoch nicht gezeigt.

Die einzelnen TEM-Rohre des TEG sind in ihren jeweiligen längsaxialen End-Breichen mittels Böden 5 miteinander verbunden.

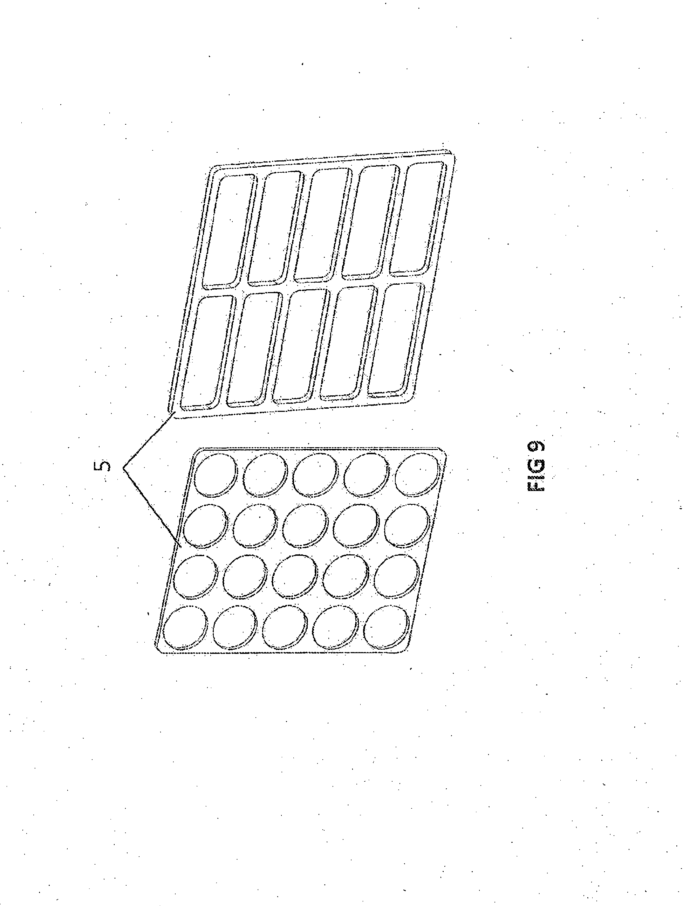

Fig. 9 zeigt eine isometrische Darstellung eines Bodens 5 für ein TEG mit TEM-Rund-Rohren sowie eine isometrische Darstellung eines Bodens 5 für ein TEG mit TEM-Rechteck-Rohren, gemäß Ausführungsbeispielen der vorliegenden Erfindung.

Der Boden 5, trennt die Stoffströme des ersten und zweiten Mediums an Stirnseiten der Wärmeübertragungsstrecke, also an deren Ein- und Austritt, und somit in axialer Richtung. Der Boden 5 ist ein umgeformtes Blech, das z.B. aus Edelstahl gefertigt ist. Er ist mit einer Vielzahl an Aussparungen ausgestattet, die in ihrer Anzahl, Anordnung und Form den TEM-Rohren entsprechen, die mit den Aussparungen des Bodens 5 verbunden werden können. Die Verbindung kann z.B. mit Laser-Schweißen erfolgten. Dazu können die Rohre zuvor in die Aussparungen des Bodens 5 gesteckt werden. Es wird im Allegemeinen jeweils ein Boden 5 an einen Ein- und Austritt des Rohrbündels gefügt. Die Aussparungen und die umfängliche Außenkontur des Bodens 5 können mit Durchzügen versehen werden.

Zur mediendichten Montage des erfindungsgemäßen TEG kann die umfängliche Kontur des Bodens mit einem Gehäuse und/oder einem Diffusor des TEG verbunden werden. Auch hier kann als Verbindungstechnik z.B. Laser-Schweißen eingesetzt werden,

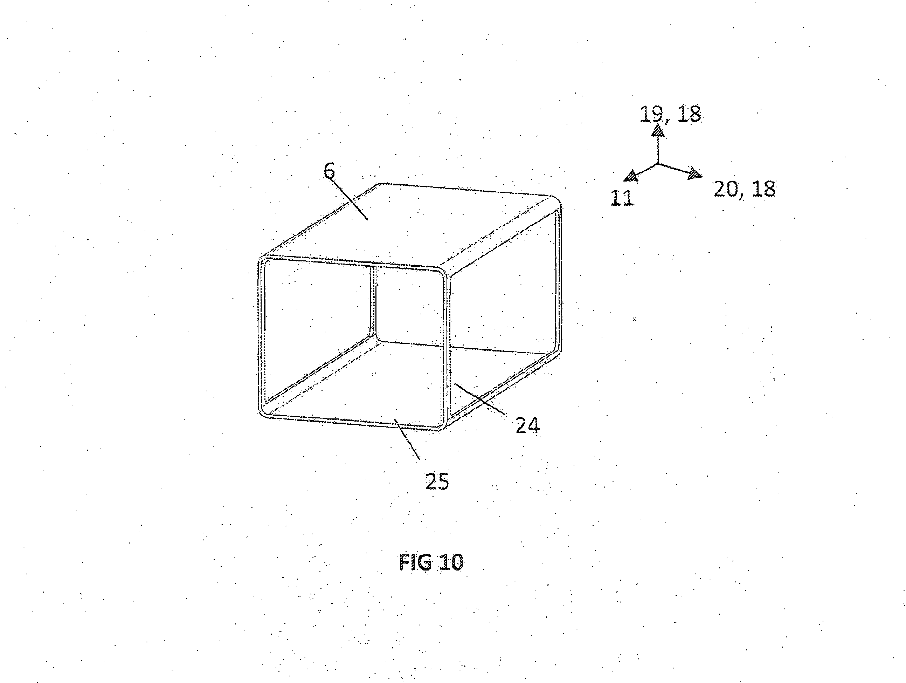

Eine isometrische Darstellung eines Ausführungsbeispiels eines Gehäuses 6 für einen erfindungsgemäßen TEG ist in Fig. 10 gezeigt.

Das Gehäuse 6 ist bezüglich seiner Form ein rundes oder vieleckiges, abgerundetes Rohr. Das Gehäuse 6 kann in axialer Richtung 11 mehrfach abgesetzt sein. Zwischen einer Außenseite der TEM-Rohre und einer Innenseite des Gehäuses 6 kann das erste oder das zweite Medium quer, also in den Richtungen 18, 19, 20, oder längs, also in der Richtung 11, bezüglich der TEM-Rohre geführt werden. Das Gehäuse 6 trennt somit den Stoffstrom des ersten oder zweiten Mediums in radialer Richtung 18 entlang der Wärmeübertragungsstrecke von der umgebenden Atmosphäre. Eine dem Gehäuse 6 vor- und nachgeschaltete Sammlung dieses Stoffstromes ist folglich nicht notwendig.

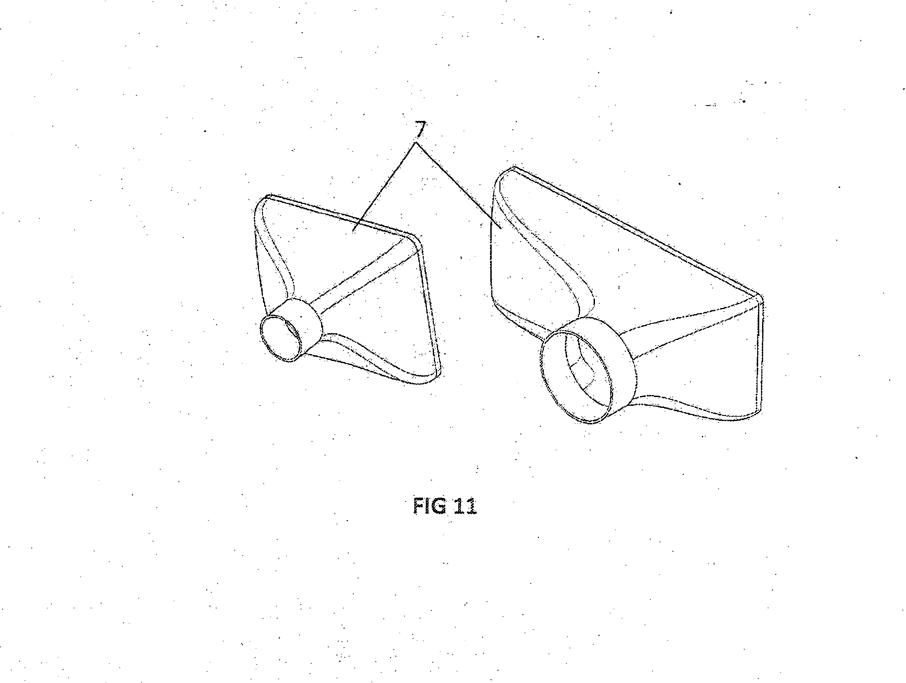

Das Gehäuse 6 ist radial (18) auf zwei gegenüberliegenden Seiten jeweils mit einer Öffnung 24 ausgestattet. Diese Öffnung 24 kann mit einem Durchzug versehen werden. In Fig. 10 ist lediglich eine der beiden radialen Öffnungen 24 mit einem Bezugszeichen versehen. Die beiden Öffnungen 24 können mit jeweils einer Anschlussleitung oder einem radialen Diffusor verbunden sein. Über die Öffnungen 24 kann das erste oder das zweite Medium in das Gehäuse 6 hinein- bzw. hinausgeleitet werden. Entlang der axialen Richtung 11 ausgerichtete Enden 25 des Gehäuses 6 können über dessen Innen- oder Außenseite mit den Böden und/oder mit zwei weiteren Diffusoren verbunden werden, z.B. mittels Laser-Schweißen. Der TEG kann somit zwei radial angeordnete und zwei axial angeordnete Diffusoren aufweisen. Die Diffusoren sind in Fig. 10 nicht gezeigt und werden im Zusammenhang mit der folgenden Fig. 11 erläutert.

In dem Gehäuse kann eine weitere kleine Öffnung vorgesehen werden, durch die beispielsweise Elektroleitungen der TEM-Rohre geführt, werden können. Die Öffnung würde z.B. mit Kleber entsprechend abgedichtet sein müssen. Eine derartige Öffnung ist in Fig. 10 nicht gezeigt.

Fig. 11 zeigt zwei Ausführungsbeispiele von unterschiedlich ausgeformten Diffusoren 7 für einen erfindungsgemäßen TEG. Die Diffusoren 7 können als radiale Diffusoren an zwei sich radial gegenüberliegenden Enden des Gehäuses des erfindungsgemäßen TEG oder als axiale Diffusoren an zwei sich axial gegenüberliegenden Enden des Gehäuses des erfindungsgemäßen TEG angeordnet sein.

Der Diffusor 7 kann aus einem umgeformten und/oder geschweißten Blech gebildet sein. Er hat zwei Öffnungen. Auf der Seite der ersten Öffnung ist der Diffusor 7 mit einer Anschlussleitung verbunden, auf der Seite der zweiten Öffnung mit dem Boden und/oder mit dem Gehäuse des TEG. Die Öffnungen unterscheiden sich naturgemäß und im Allegemeinen in ihrem Durchmesser. Der Diffusor 7 ist strömungstechnisch in vorteilhafter Weise gestaltet. Der Raum zwischen einer Innenwand eines axialen Diffusors und dem Boden bildet eine Kammer, die das Medium, das mit den TEM-Rohren kommuniziert, vor dem Eintritt in die und nach Austritt aus den Rohren sammelt. Demgemäß sind im Allgemeinen in axialer Richtung zwei Diffusoren je TEG vorgesehen.

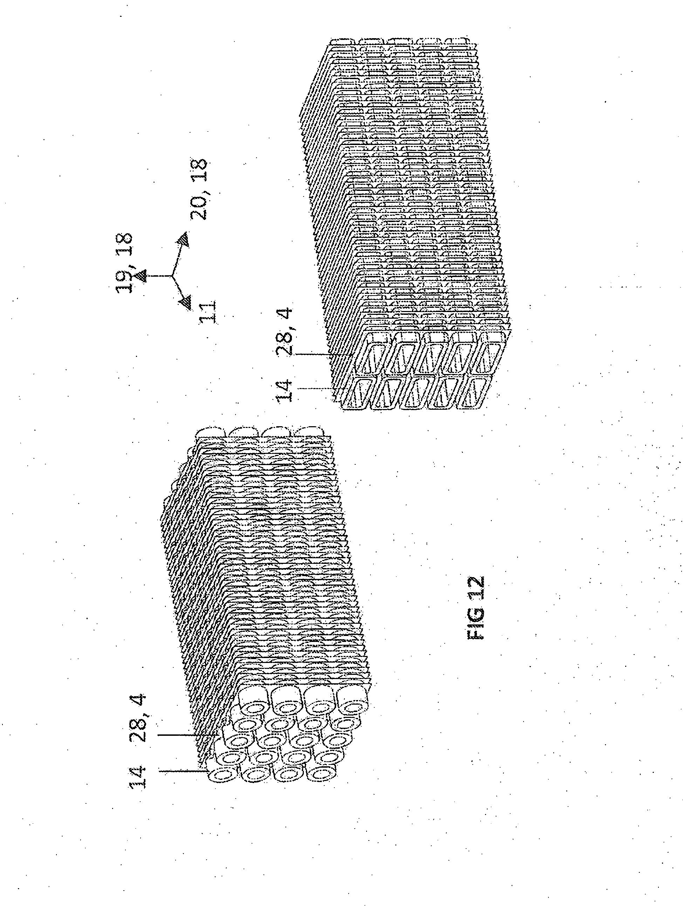

Fig. 12 zeigt isometrische Darstellungen im Schnitt von zwei unterschiedlichen erfindungsgemäßen Ausführungen von TEG-Blöcken. Beide in der Fig. 12 gezeigten TEG-Blöcke weisen eine Anordnung aus einer Mehrzahl von TEM-Rohren 14 und einer Mehrzahl von Führungsblechen 28 auf, wobei bei dem oben abgebildeten TEG-Block die Rohre 14 einen runden Querschnitt aufweisen und bei dem unten abgebildeten TEG-Block die Rohre 14 einen rechteckigen Querschnitt aufweisen.

Bei den in Fig. 12 gezeigten Ausführungen des TEG_wird das heiße Medium, z.B. Abgas, auf der Außenseite der TEM-Rohre 14 geführt, und das kalte Medium, z.B. Kühlmittel, wird auf der Innenseite der TEM-Rohre 14 gerührt. Das kalte Medium in den TEM-Rohren 14 strömt dabei im Wesentlichen in axialer Richtung 11, was eine eventuell durch nicht dargestellte Turbulenzeinlagen ausgelöste Drallströmung beinhalten kann. Die TEM-Rohre 14 werden dabei auf deren Außenseite von dem heißen Medium quer, also in den Richtungen 18, 19, 20, angeströmt. Der TEG ist somit thermodynamisch ein Kreuzstrom-Wärmetauscher.

Auf der Außenseite der TEM-Rohre 14 ist eine Berippung 28 vorgesehen. Dabei handelt es sich um parallel übereinander gestapelte bzw. in axialer Richtung 11 geschichtete dünne Blechstreifen 28 als Führungsbleche, die von dem Bündel von TEM-Rohren 14 orthogonal zu den Blechen 28 durchdrungen werden. Hierzu weist jeder Blechstreifen 28 Aussparungen auf, deren Form der Außenkontur der TEM-Rohre 14 entspricht. Diese können im Querschnitt Sowohl rund als auch rechteckig sein oder eine davon abweichende Form aufweisen. Die Blechstreifen 28 können mit einer Profilierung 4 versehen sein.

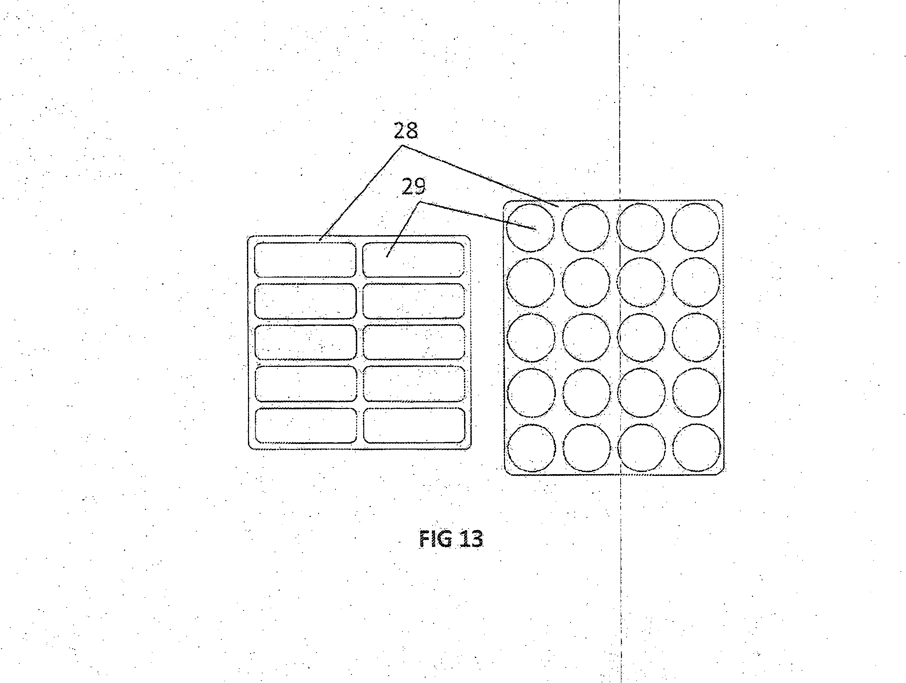

Fig. 13 zeigt ein Führungsblech 28 für eine Mehrzahl von Rechteck-TEM-Rohren sowie ein Führungsblech 28 für eine Mehrzahl von Rund-TEM-Rohren, jeweils in einer Draufsicht, gemäß Ausführungsbeispielen der vorliegenden Erfindung.

Aussparungen 29 in den Blechstreifen 28 können Durch- oder Einzüge und/oder Einführschrägen aufweisen, die das Fügen der Blechstreifen 28 mit den TEM-Rohren erleichtern bzw. eine großflächigere Anbindung der Blechstreifen 28 an die TEM-Rohre gewährleisten können. Auf diese Weise kann der Wärmedurchgangswiderstand reduziert werden. Die Durch- oder Einzüge bzw. Einführschrägen sind in Fig. 13 nicht gezeigt. Eine weitere Funktion der Aussparungen 29 kann die Haltung und Positionierung der TEM-Rohre entlang der Wärmeübertragungsstrecke sein. In Fig. 13 ist bei beiden Ausführungsbeispielen für das Führungsblech 28 lediglich eine Aussparung 29 mit einem Bezugszeichen versehen.

Beispielsweise ist die Verbindung zwischen einer Aussparung 29 und einem TEM-Rohr bzw, einem Durchzug einer Aussparung und einem TEM-Rohr eine Presspassung, wobei die Aussparung 29 bzw. die Aussparung mit Durchzug 30 im Vorgang des Fügens des Bleches 28 mit dem TEM-Rohr umgeformt werden kann. Die Verbindung kann daher kraft- oder formschlüssig sein, also eine mechanische Verbindung darstellen. Die Verbindung kann alternativ oder ergänzend auch eine stoffschlüssige sein, wie sie z.B. mittels einer Lösung hergestellt werden kann. Die Durchzüge vergrößern die Kontaktflächen an dem TEM-Rohr und können als Abstandshalter der Blechstreifen 28 zueinander dienen. Die benachbarten Blechstreifen 28 berühren sich dann an diesen Stellen.

Bei dern TEG sind die Blechstreifen im Allgemeinen zueinander beabstandet. Zwischen den Blechstreifen strömt z.B. das heiße Medium. Der axiale Abstand der Blechstreifen zueinander kann erfindungsgemäße 1-6 mm, und bevorzugt 2-4,5 mm betragen. Ein geringerer Abstand könnte den Druckabfall auf Grund von Fouling, z.B. aufgrund von Ruß- und Partikelablagerungen, übermäßig ansteigen lassen. Ein größerer Abstand wiederum könnte den Nachteil aufweisen, dass sich der Wärmeübergang und die Übertragungsflächen reduzieren würden, was eine Leistungsminderung zur Folge hätte.

Um eine Beabstandung zwischen den Blechstreifen zu ermöglichen bzw. zu verbessern, können diese über Einprägungen, gebogene Ausklinkungen und/oder Laschen verfügen, die als Abstandhalter der Blechstreifen zueinander dienen. Benachbarte Blechstreifen berühren sich dann an diesen Stellen.

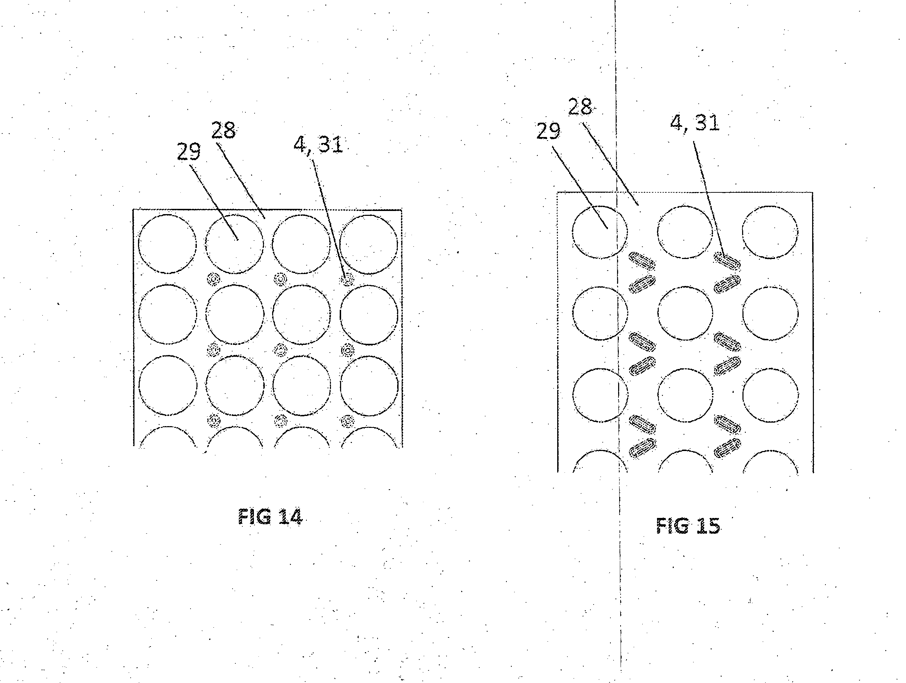

Fig. 14 bis 19 zeigen in Draufsichten entsprechende Ausführungsbeispiele von Blechstreifen 28 mit Aussparungen 29 für Rund- bzw. Rechteckrohre und unterschiedlichen Profilierungen 4.

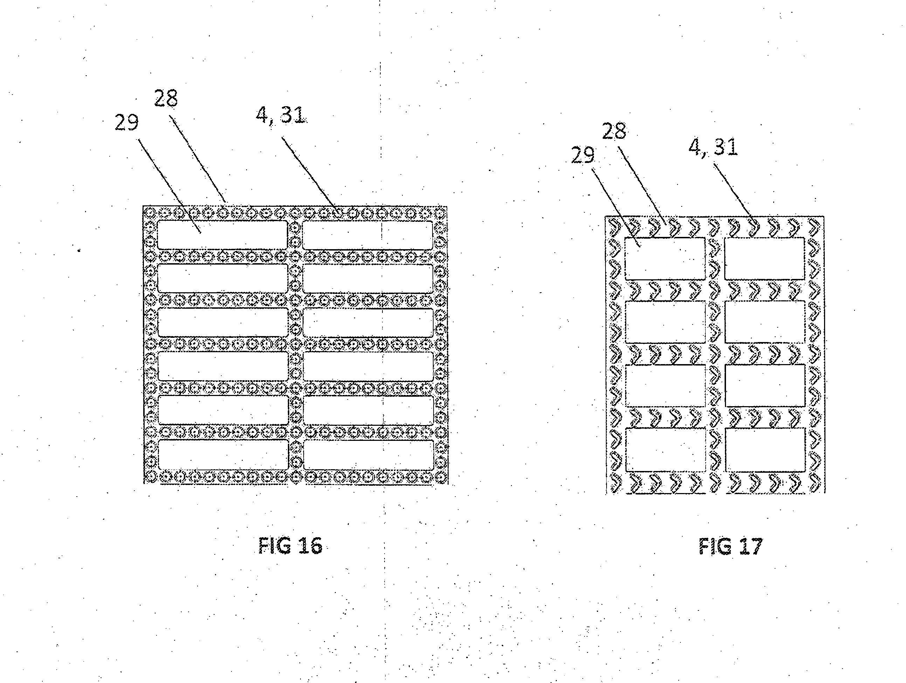

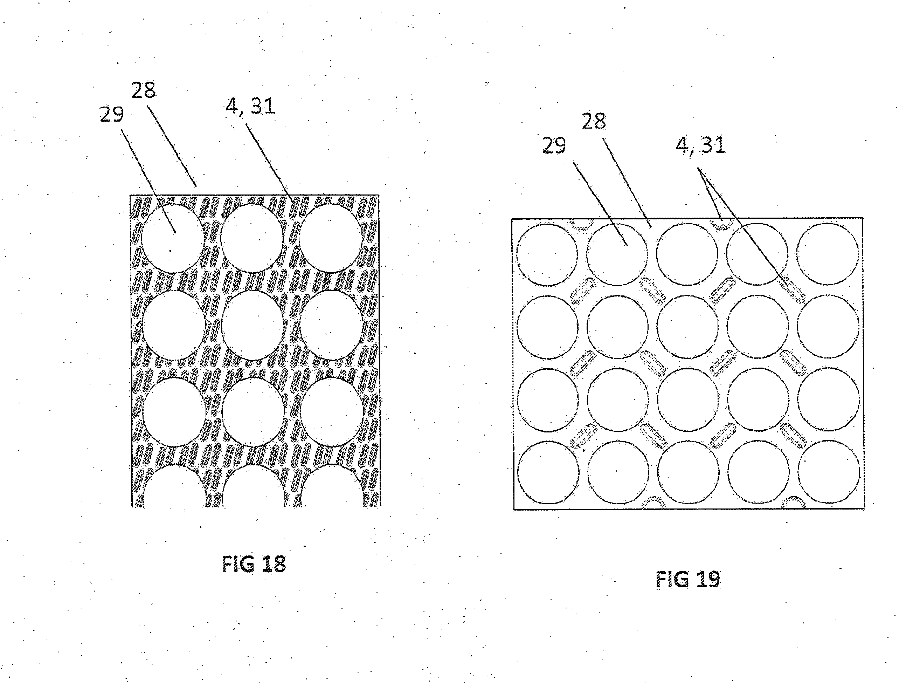

Die Blechstreifen 28 können oberflächen- und wärmeübergangerhöhende Profilierungen 4 bzw. Prägungen 4 und/oder Stanzungen 4/ bzw. Ausklinkungen 4 wie Winglets 4 und/oder Noppen 4 und/oder Rippen 4 und/oder Kiemen 4 aufweisen, welche als Abstandshalter 31 der Blechstreifen 28 zueinander dienen können. Dabei sind in Fig. 14 runde Abstandshalter (Ausklinkungen) in Kombination mit runden Öffnungen/Aussparungen 29 dargestellt, während in Fig. 15 längliche Abstandshalter 4, 31 in Kombination mit runden Öffnungen 29 gezeigt sind, wobei die länglichen Abstandshalter 4, 31 eine Anströmungsfläche zur Führung des zweiten Mediums bilden. In Fig. 16 sind runde Noppen 4, 31 in Kombination Aussparungen 29 für rechteckförmige Flachrohre dargestellt, wobei in Fig. 7 eine Kombination von Winglet-förmigen Profilierungselementen 4, 31 in Kombination mit Aussparungen 29 für rechteckförmige Flachrohre dargestellt sind. Fig. 18 zeigt eine Darstellung mit einer Kombination von Aussparungen 29 für runde Rohre mit länglichen Profilierungselementen 4, 31, wogegen in Fig. 19 eine Darstellung einer Kombination von Aussparungen 29 für runde Rohre mit runden Profilierungselementen 4, 31 am Rand des Führungsbleches und länglichen Profilierungselementen 4, 31 zwischen diagonal angeordneten Aussparungen für runde Rohre wiedergegeben ist.

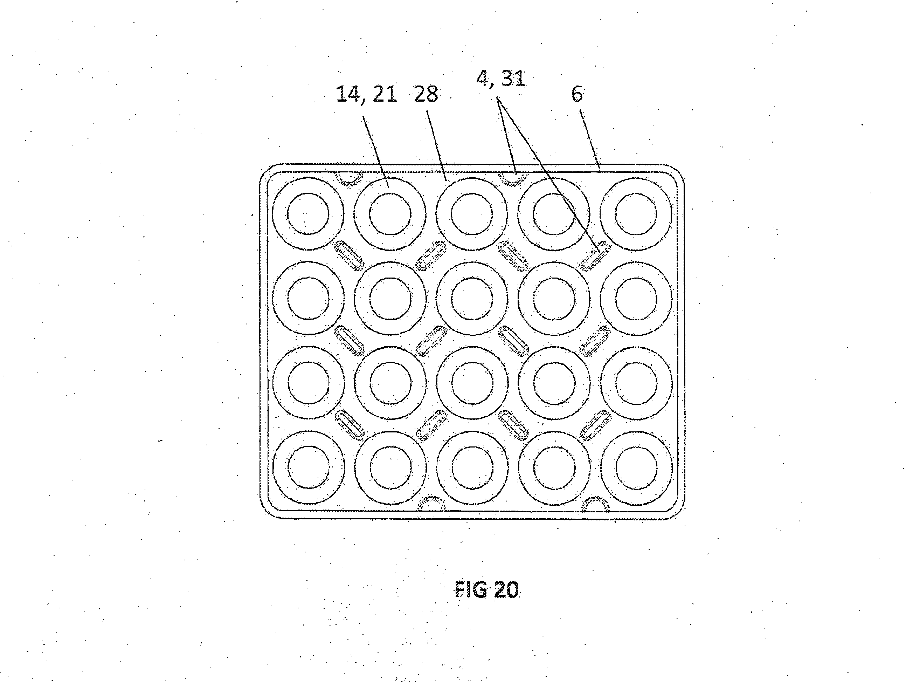

Fig. 20 zeigt eine Querschnittsdarstellung durch ein erfindungsgemäßes TEG gemäß einem Ausführungsbeispiel der vorliegenden Erfindung. Gezeigt ist das Gehäuse 6, ein Führungsblech 28 mit der Profilierung 4 als Abstandshalter 31 sowie die fluchtende Anordnung 21 der TEM-Rohre 14.

Gemäß einem Ausführungsbeispiel der Erfindung dienen die Profilierungen 4 der Blechstreifen 28 nicht nur dazu, die Wärmeübertragungsfläche zu vergrößern und die laminare Grenzschicht in der Strömung aufzubrechen und/oder um Verwirbelungen in der Strömung zu verursachen, wodurch eine Leistungssteigerung des TEG erzielt werden kann. Die Profilierung 4 dient auch dazu, die Strömung z.B. des zweiten Mediums in einer vorteilhaften Weise zu führen und/oder umzulenken. Dies kann insbesondere dann notwendig werden, wenn auf Grund von Bauraumgründen das Bündel von TEM-Rohren 14 eine relativ hohe Packungsdichte aufweist. Dann folgen die TEM-Rohre 14 in den Dimensionen 18, 19, 20 sehr nahe aufeinander, wodurch die unerwünschte Entstehung von Totwassergebieten zwischen zwei benachbarten bzw. zwei nacheinander folgenden TEM-Rohren 14 gefördert werden kann. Dies ist insbesondere der Fall, wenn bei fluchtend 21 angeordneten TEM-Rohren 14 der heiße Stoffstrom in der radialen Richtung 18 ungehindert strömen kann. Um dies zu unterbinden sind die Profilierungen 4 erfindungsgemäß wie in Fig. 20 gezeigt. angeordnet.

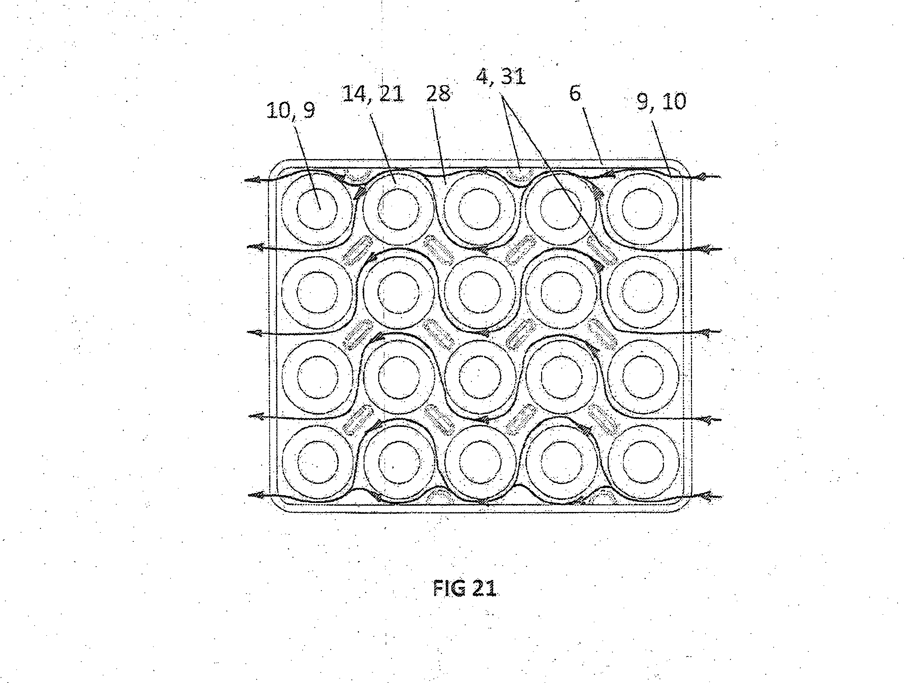

Fig. 21 zeigt die Schnittansicht des erfindungsgemäßen TEG aus Fig. 20, ergänzt um eine Strömungsführung für eines des ersten und zweiten Mediums 9, 10, wobei das andere des ersten und zweiten Mediums 10, 9 in den TEM-Rohren 14 geführt wird. In Fig. 21 ist deutlich zu sehen, dass sich die Strömungsführung aus der Anordnung der Profilierung 4 bzw. Abstandshalter 31 (Ausklinkung) gegenüber der fluchtenden Anordnung 21 der TEM-Rohre 14 ergibt.

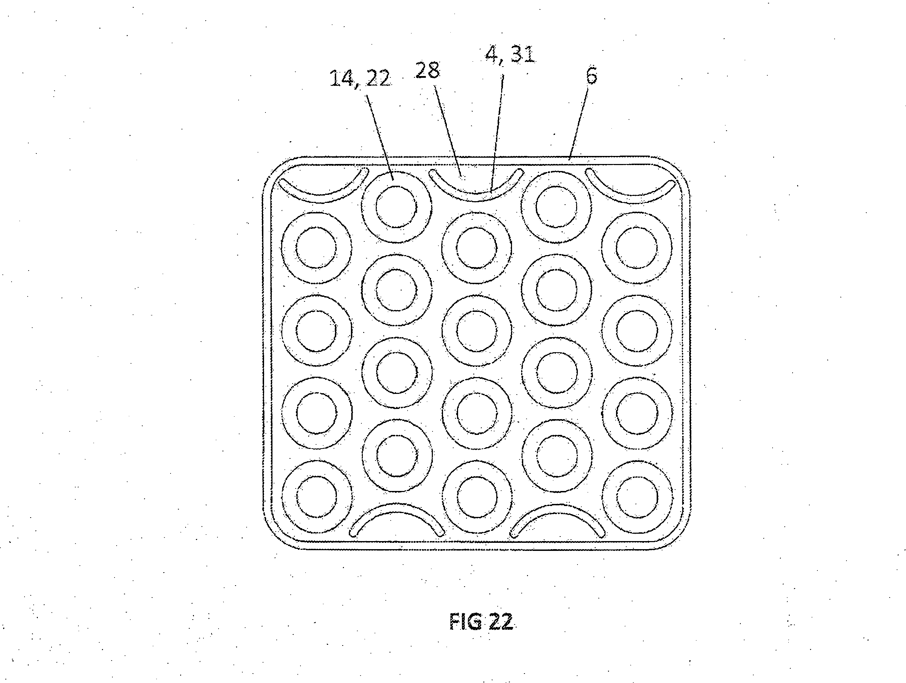

Fig. 22 zeigt einen Querschnitt durch ein erfindungsgemäßes TEG gemäß einem Ausführungsbeispiel der vorliegenden Erfindung. Gezeigt ist das Gehäuse 6, ein Führungsblech 28 mit der Profilierung 4 am Rand des Führungsbleches als Abstandshalter 31 und als Führungselement um das zweite Medium zu einem zurückgesetzten Rohr zu führen. Ferner ist aus der Darstellung der Fig. 22 die versetzte Anordnung 22 der TEM-Rohre 14 ersichtlich.

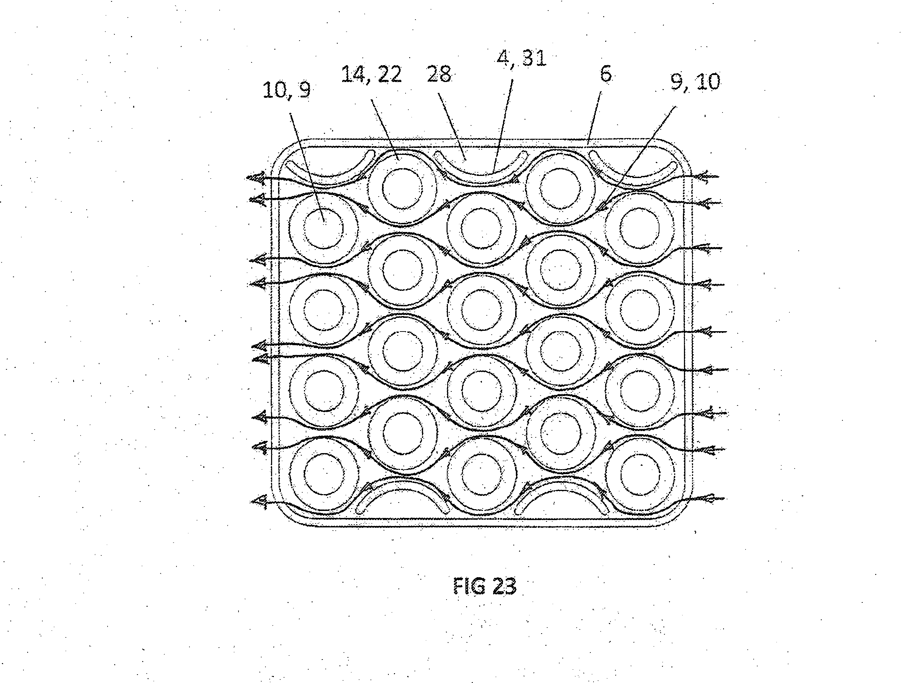

Fig. 23 zeigt die Schnittansicht des erfindungsgemäßen TEG aus Fig. 22, ergänzt um eine meanderförmige Strömungsführung für eines des ersten und zweiten Mediums 9, 10, wobei das andere des ersten und zweiten Mediums 10, 9in den TEM-Rohren 14 geführt wird.

Aus den Figuren 22 und 23 ist ersichtlich, dass bis auf einen Randbereich des Führungsbleches 28 auf eine Profilierung 4 zur vorteilhaften Steuerung des Medienstromes 9, 10 verzichtet werden kann. Sind nämlich die TEM-Rohre 14 entlang des heißen, radialen 18 Stoffstroms versetzt 22 angeordnet, wobei keine Anpassung der Gehäusegeometrie 6 an das Bündel von TEM-Rohren 14-erfolgt, kann die Profilierung 4 in diesem Fall auch dazu dienen, in vorteilhalter Weise ähnliche Strömungsspalte in dem gesamten Außenseiten-Bereich der TEM-Rohre 14- zu generieren, so dass eine günstige, gleichmäßige Verteilung der Massenstromdichte, also des lokalen Massenstroms, erzielt werden kann. Diese Ausführung bietet sich insbesondere dann an, wenn die Gehäusegeometrie 6 nicht in besonderer Weise an die versetzten TEM-Rohre 14 angepasst ist.

Wie im Zusammenhang mit den Figuren 20 bis 23 erläutert, können also die TEM-Rohre 14 entlang des heißen, radialen 18 Stoffstroms 9 fluchtend 21 oder versetzt 22 angeordnet sein.

Beispielsweise kann die Gehäusegeometrie 6 über den Querschnitt betrachtet an das Bündel von TEM-Rohren 14- angepasst sein, so dass in vorteilhafter Weise ähnliche Strömungsspalte im gesamten Außenseiten-Bereich der TEM-Rohre 14, vor allem in Breitenrichtung 19, vorherrschen, so dass eine günstige, gleichmäßig Verteilung der Massenstromdichte erzielt werden kann.

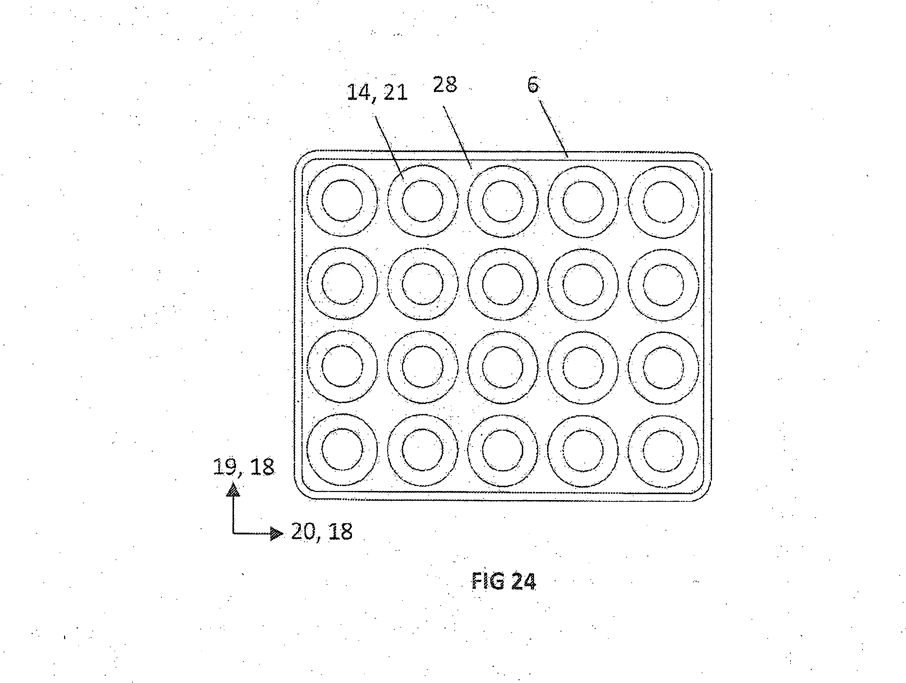

Figuren 24 bis 26 zeigen in Querschnittsdarstellungen Ausführungsbeispiele von Gehausegeometrien 6 des erfindungsgemäßen TEG in Bezug auf eine fluchtende bzw. versetzte Anordnung der TEM-Rohre 14.

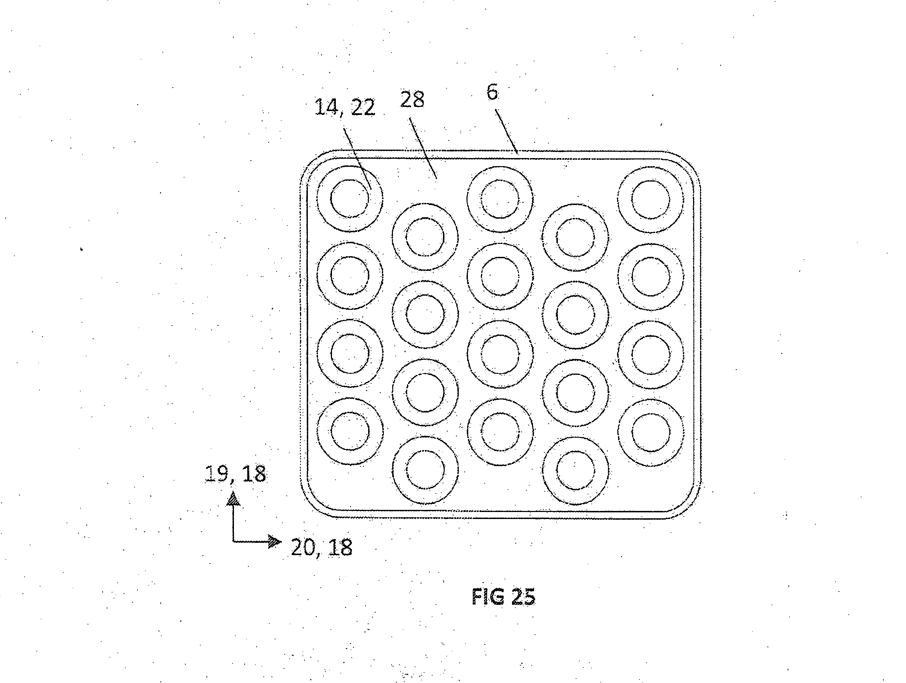

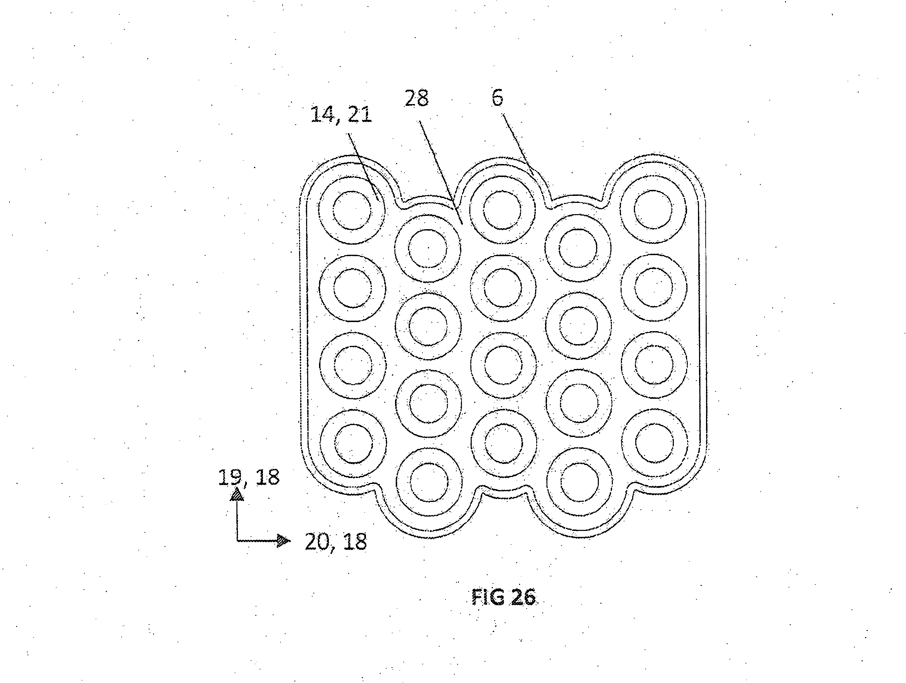

Dabei ist bei den in den Figuren 24 und 26 gezeigten Ausführungsbeispielen des TEG eine Anpassung bzw. eine Anpassung in besonderer Weise der Gehäusegeometrie 6 an die Anordnung der TEM Rohre 14 gegeben, wobei die TEM-Rohre 14 in Fig. 24 fluchtend und in Fig. 25 und 26 versetzt angeordnet sind, wobei in Fig. 25 ein rechteckförmiges Gehäuse 6 verwendet wird und in Fig. 26 ein unregelmäßiges Gehäuse mit Ausbuchtungen für die nicht-fluchtend angeordneten Rohre vorgesehen ist. Somit entsprechen die Abstände der Gehäusewandung 6 zu den TEM-Rohren 14 in Breitenrichtung 19 und/oder radial 18 im Wesentlichen und/oder näherungsweise den Abständen der TEM-Rohre 14 in Breitenrichtung 19 und/oder radial 18 zueinander. Der Abstand der TEM-Rohre 14 zueinander beträgt in Breitenrichtung 19 und/oder radial 18 erfindungsgemäß beilspielsweise 1-6 mm, bevorzugt 2-4,5 mm.

Im Gegensatz dazu ist in Fig. 25 ein Ausführungsbeispiel der Gehäusegeometrie 6 gezeigt, das sich nicht in besonderer Weise an das TEM-Rohrbündel (14) anpasst.

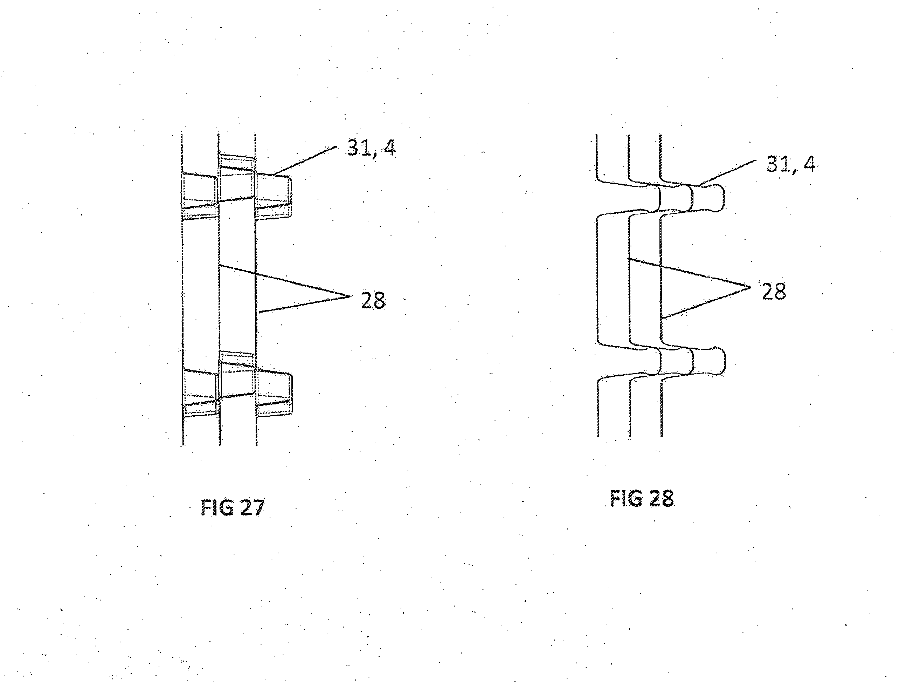

Figuren 27 und 28 zeigen jeweils in einer Seitenansicht Ausführungsbeispiele eines Blechstreifen-Stapels 28 mit Profilierung 4 als Abstandshalter 31 und/oder zur Strömungsführung eines Mediums.

Gemäß dem in Fig. 27 gezeigten Ausführungsbeispiel der Erfindung entspricht die Höhe der Profilierung 4 der Blechstreifen 28 dem Abstand der Blechstreifen 28 zueinander.

Diese Höhe kann den Abstand jedoch überragen, wenn die Profilierungen 4 der Blechstreifen 28 teilweise in das Negativ der Profilierungen 4 des benachbarten Blechstreifens 28 gesteckt werden, wie dies anhand des in Fig. 28 gezeigten Ausführungsbeispiels zu erkennen ist. So kann eine Höhe der Profilierungen 4 der Blechstreifen 28 erfindungsgemäß mindestens einem halben Abstand zwischen zwei Blechstreifen 28 entsprechen.

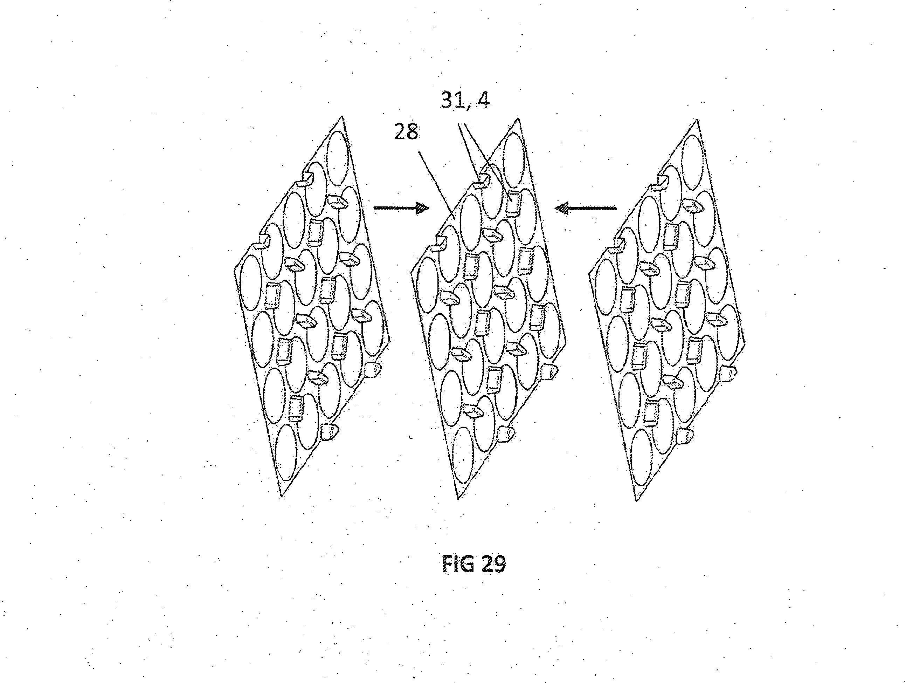

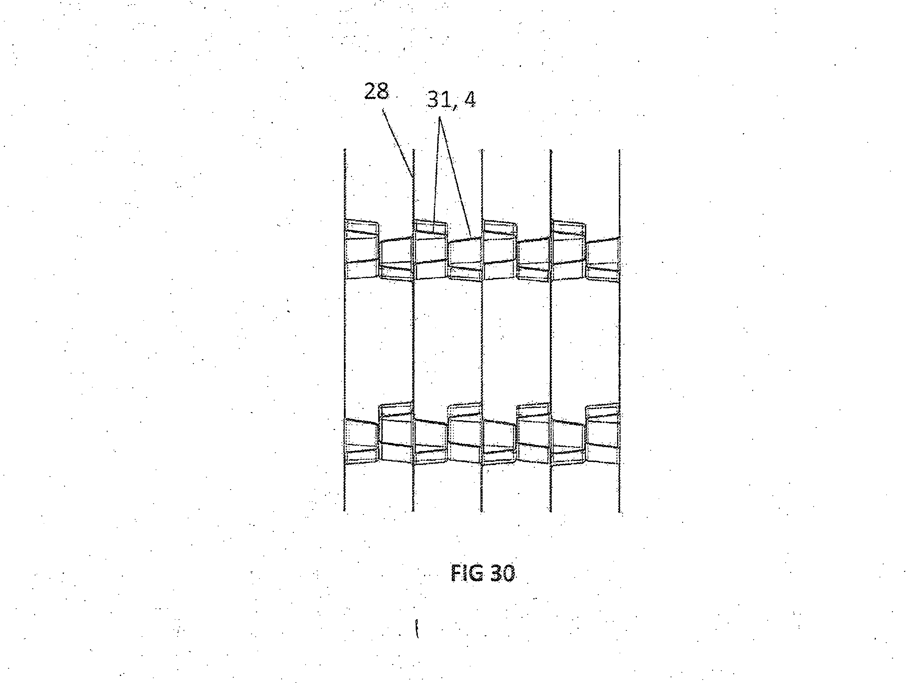

Figuren 29 und 30 zeigen Anordnungsmöglichkeiten von Führungsblechen 28 in dem erfindungsgemäßen TEG, gemäß Ausführungsbeispielen der vorliegenden Erfindung.

Die Blechstreifen 28 können gleichartig und in gleicher Ausrichtung zueinander gestapelt werden.

Gemäß der in Fig. 29 gezeigten Prinzipdarstellung zum Fügen einer Mehrzahl von Führungsblechen 28 können die benachbarten Blechstreifen 28 alternativ in vorteilhafter Weise abwechselnd zueinander um 180° verdreht angeordnet sein, wobei eine Mitte des Blechstreifens 28 den Drehpunkt und die Orthogonale zu dem Blechstreifen 28 die Drehachse darstellt. Hierdurch kann eine gleichmäßigere Temperaturverteilung an den Wandungen der TEM-Rohre erzielt werden, indem lokale Wärmeübergangsunterschiede über die gesamte Wärmeübertragungsfläche ausgeglichen werden. Die Ausrichtung der Profilierungen 4 in deren Höhe bleibt dabei erhalten. Die Profilierungen 4 bzw. Abstandshalter 31 weisen daher in die gleiche Richtung.

Ebenso können benachbarte Blechstreifen 28 erfindungsgemäß abwechselnd zueinander um 180° verdreht bzw. tangential verdreht angeordnet sein, wie dies anhand des in Fig. 30 gezeigten Ausführungsbeispiels einer Führungsblechanordnung 28 gezeigt ist. Hier stellt die Mitte des Blechstreifens 28 den Drehpunkt und die Tangente zu dem Blechstreifen 28 in der Breitenrichtung oder Tiefenrichtung die Drehachse dar. Die Ausrichtung der Profilierungen 4 zweier benachbarter Blechstreifen 28 bleibt dabei nicht erhalten, indem diese entweder zueinander gerichtet sind oder voneinander weg weisen.

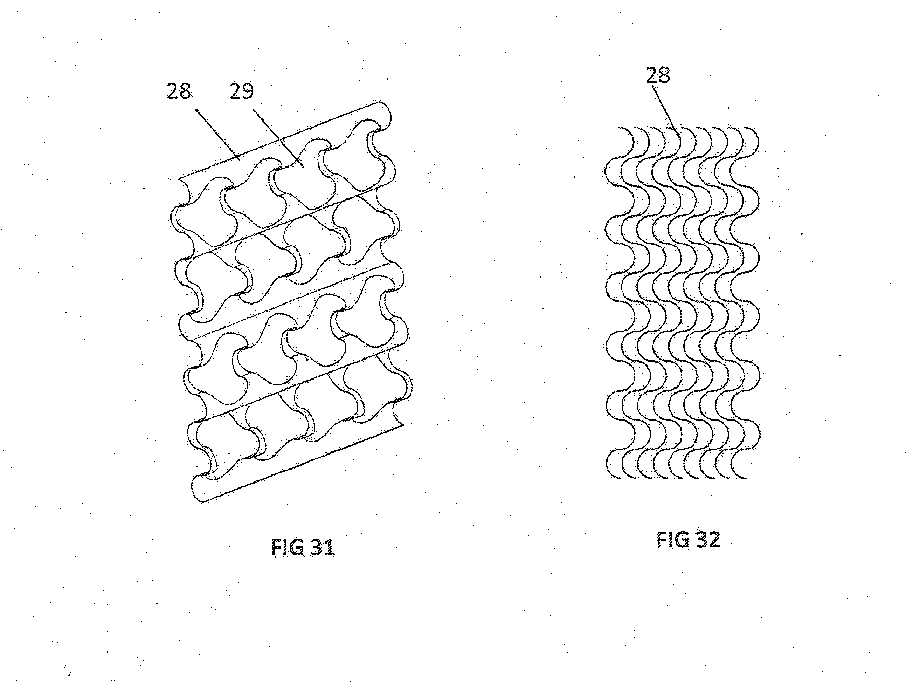

Fig. 31 zeigt in einer isometrischen Darstellung ein Ausführungsbeispiel eines unebenen Blechstreifens 28. Der Blechstreifen 28 ist im Bereich der Aussparungen 29 gewellt. Gemäß diesem Ausführungsbeispiel können die Blechstreifen 28 auch zur Halterung und Positionierung der TEM-Rohre innerhalb des TEG dienen.

Fig. 32 zeigt in einer Seitenansicht einen Stapel aus einer Mehrzahl von unebenen Blechstreifen 28 gemäß dem Ausführungsbeispiel aus Fig. 31.

Die Ausführungen gemäß den Figuren 29, 30, 31. und 32 können in einer weiteren Ausführung kombiniert werden.

Alternativ kann man den im Zusammenhang mit den Figuren 1 bis 32 beschriebene Wärmetauscher nicht nur zur Stromgewinnung, sondern auch zum Heizen und/oder Kühlen verwunden, so dass der Wärmetauscher dann als ein thermoelektrischer Heizer/Kühler (TE-HK) wirkt.

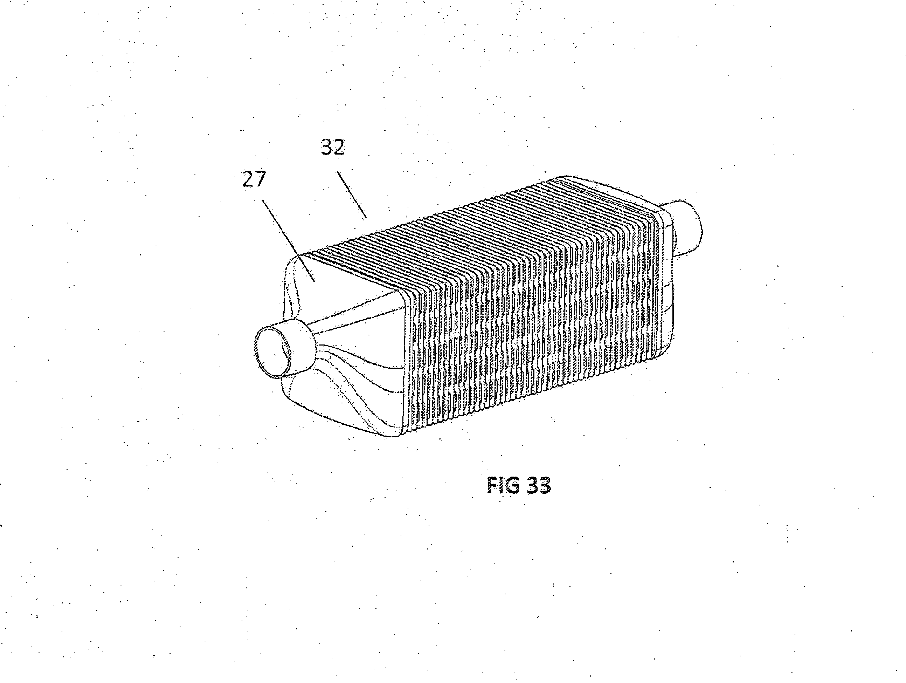

Fig. 33 zeigt entsprechend eine isometrische Darstellung einer Ausführung des Wärmetauschers als thermoelektrischer Heizer bzw. Kühler 32. Der TE-HK 32 ist ohne ein Gehäuse, jedoch mit zwei sich gegenüberliegenden axialen Diffusoren 27 ausgebildet, wobei lediglich einer der axialen Diffusoren 27 mit einem Bezugszeichen versehen ist.

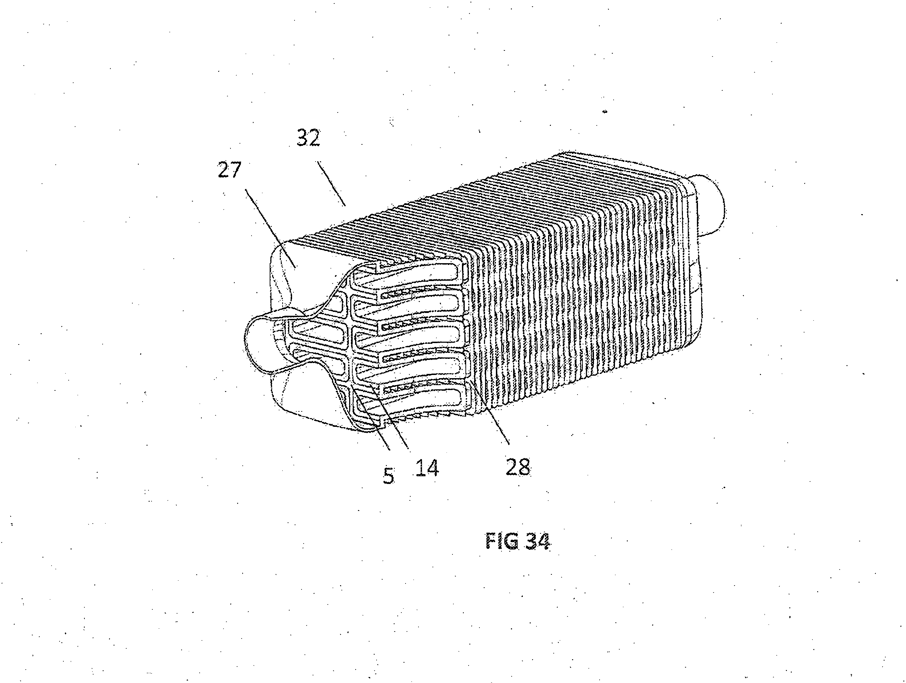

Fig. 34 zeigt den TE-HK 32 aus Fig. 33 in einem Längsschnitt. Gezeigt sind ein Boden 5, TEM-Rohre 14, Diffusoren 27 sowie Führungsbleche 28. Der Übersichtlichkeit halber ist lediglich jeweils eines der TEM-Rohre 14, einer der Diffusoren 27 sowie eines der Führungsbleche 28 mit einem Bezugszeichen versehen.

Gemäß dem in Fig. 34 gezeigten Ausführungsbeispiel ist der TE-HK 32 ein Wärmetauscher, der mit thermoelektrischen Modulen (TEM) bzw. TEM-Rohren 14bestückt ist, die wiederum thermoelektrisch aktive Materialien beinhalten. Werden die TEM mit Strom betrieben, kann der TE-HK 32 als Heizer oder als Kühler genutzt werden, da die beiden gegenüberliegenden Hauptfläche der TEM einerseits mit einer Wärmequelle eines ersten Mediums, z.B. Kühlmittel oder Luft, und andererseits mit einer Wärmesenke eines zweiten Mediums, z.B. Luft oder Kühlmittel, in Kontakt stehen, Die TEM entziehen dabei dem einen Medium Wärme und führen sie dem anderen Medium im Sinne einer Wärmepumpe gemäß dem Peltier-Effekt zu. Die Medien werden im TE-HK 32 entsprechend aneinander vorbeigeführt.

Wird die Luft an einer Außenseite der TEM-Rohre 14 geführt, kann der TE-HK 32 ohne Gehäuse und ohne radiale Diffusoren ausgeführt sein. Wird das Kühlmittel oder Kältemittel an der Außenseite der TEM-Rohre 14 geführt, kann der TE-HK 32 ohne axiale Diffusoren 27 ausgeführt sein.

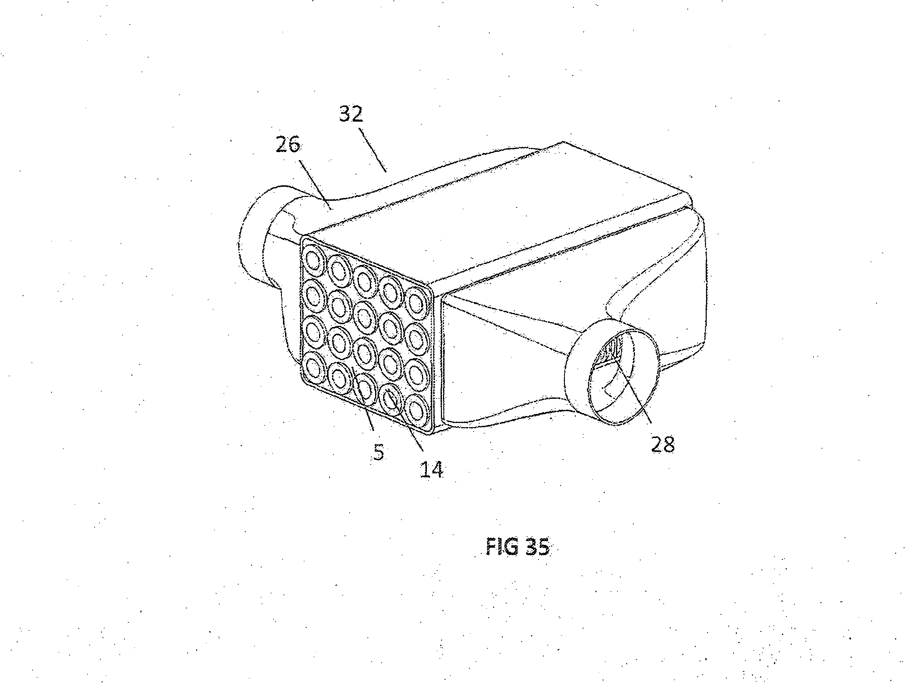

Fig. 35 zeigt ein weiteres Ausführungsbeispiel eines thermoelektrischen Heizers bzw. Kühlers 32, der keine axialen Diffusoren, jedoch radiale Diffusoren 26 aufweist.

Der im Zusammenhang mit Figuren 1 bis 32 beschriebene TEG und der im Zusammenhang mit Figuren 33 bis 35beschriebene thermoelektrischer Heizel/Kühler TE-HK können auch als Parallelströmer ausgeführt sein, so dass das erste und das zweite Medium entlang der Wärmeübertragungsstrecke entweder im Gegenstrom oder im Gleichstrom aneinander vorbeigeführt werden. Hierbei können die Öffnungen in dem Gehäuse des Wärmetauschers an den axialen Enden des Gehäuses positioniert sein. Der Apparat kann ohne radiale Diffusoren ausgeführt sein.

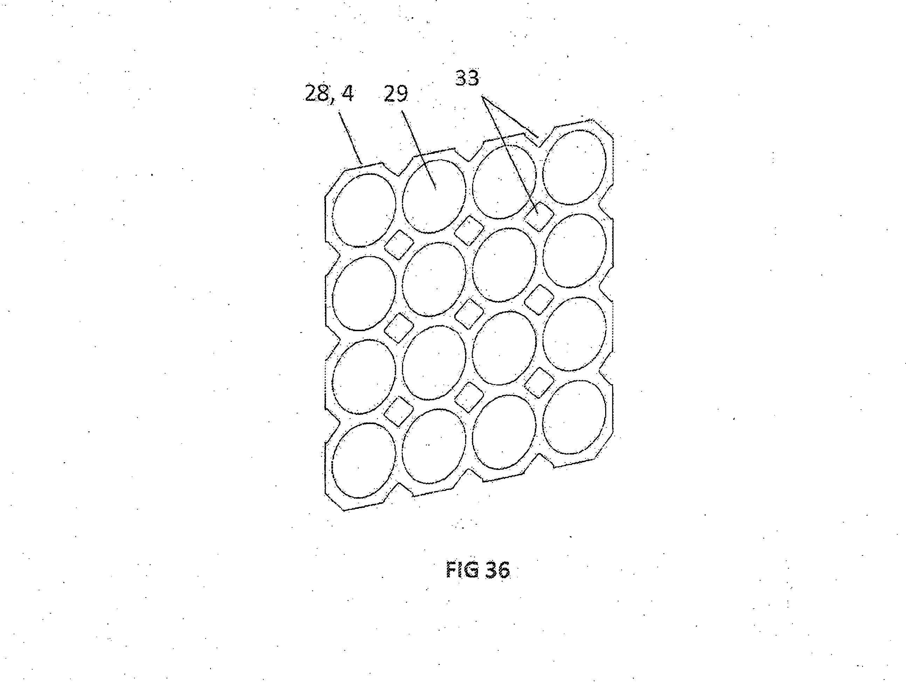

In diesem Zusammenhang zeigt Fig. 36 eine isometrische Darstellung eines Blechstreifens für eine Ausführung des Wärmetauschers als ein Parallelströmer, gemäß einem Ausführungsbeispiel der vorliegenden Erfindung. Der Blechstreifen 28 kann eine Profilierung 4 aufweisen und zusätzlich zu den Aussparungen 29 mit weiteren Aussparungen 33 ausgeführt sein, so dass eine Strö- mung an einer Außenseite der TEM-Rohre eine Mehrzahl von Blechstreifen 28des Parallelströmers durchströmen kann.

Die beschriebenen Ausführungsbeispiele sind nur beispielhaft gewählt und können miteinander kombiniert werden.

### Bezugszeichenliste

- 1: TEG: Thermoelektrischer Generator
- 2: Halterung
- 3: TEM Thermoelektrisches Modul
- 4: Profilierung: Berippung, Noppen, Kiemen, Winglets, Prägung
- 5: Boden
- 6: Gehäuse
- 7: Diffusor, Sammler
- 8: Turbulenzeinlage
- 9: Medium 1: Heiß
- 10: Medium 2: Kalt
- 11: Richtung axial
- 12: TE (thermolelektrisch)-aktive Materialien
- 13: Elektro-Leitungen
- 14: TEM-Rohr
- 15: Planare TEM
- 16: Rechteck-TEM-Rohr
- 17: Rund-Rohr-TEM
- 18: Richtung radial
- 19: Breitenrichtung
- 20: Tiefenrichtung
- 21: fluchtende Anordnung der TEM-Rohre
- 22: versetzte Anordnung der TEM-Rohre
- 23: Abstandshalter TEM-Rohre
- 24: radiale Öffnung im Gehäuse
- 25: axiale Öffnung im Gehäuse
- 26: radialer Diffusor
- 27: axialer Diffusor
- 28: Blechstreifen (=Berippung der TEM-Rohr-Außenseite)
- 29: Aussparung im Blechstreifen zur Aufnahme der TEM-Rohre
- 30: Durchzug an Aussparung
- 31: Abstandshalter Blechstreifen
- 32: Thermoelektrischer Heizer und Kühler (TE-HK)
- 33: Aussparung im Blechstreifen zur Durchströmung

## Patentansprüche

1. Wärmetauscher (1; 32) zum Austausch von Wärme zwischen zwei Medien (9, 10) in einem Fahrzeug, wobei der Wärmetauscher folgende Merkmale aufweist:
eine Mehrzahl von doppelwandigen Rohren (14; 15; 16; 17) zum Führen eines ersten Mediums (9, 10) mit einer ersten Temperatur,
**dadurch gekennzeichnet, dass**
ein thermoelektrisches Material (12) zwischen einer Innenwand des doppelwandigen Rohres und einer Außenwand des doppelwandigen Rohres oder an einer Innenwand des doppelwandigen Rohres angeordnet ist; und
mit einer Mehrzahl von mit den doppelwandigen Rohren verbundenen Führungsblechen (28) zum Führen eines zweiten Mediums (9, 10) mit einer zweiten Temperatur, wobei die Führungsbleche ausgebildet sind, um das zweite Medium an die Außenwände der doppelwandigen Rohre zu führen, um den Austausch von Wärme zwischen dem ersten und zweiten Medium zu ermöglichen.

2. Wärmetauscher (1; 32) gemäß Anspruch 1, bei dem ein Führungsblech (28) eine Mehrzahl von Aussparungen, (29) aufweist und die doppelwandigen Rohre (14; 15; 16; 17) von den Aussparungen aufgenommen sind.

3. Wärmetauscher (1; 32) gemäß einem der vorangegangenen Ansprüche, bei dem zumindest ein weiteres, insbesondere doppelwandiges, Rohr (14; 15; 16; 17) im Wesentlichen parallel zu dem Rohr in einer gemeinsamen ersten Ebene angeordnet ist und zumindest ein drittes, insbesondere doppelwandiges, Rohr in einer zu der ersten Ebene parallelen zweiten Ebene angeordnet ist, wobei das dritte Rohr in der zweiten Ebene in einer Position angeordnet ist, an der inder ersten Ebene ein Durchgang zwischen dem Rohr und dem weiteren Rohr gebildet ist.

4. Wärmetauscher (1; 32) gemäß einem der vorangegangenen Ansprüche, bei den die Innenwand einen Führungskanal für das erste Medium (9, 10) bildet, wobei die Innenwand ferner Ausbuchtungen (4) in den Führungskanal aufweist, und/oder die Außenwand ferner Erhebungen (4) in Richtung eines Flussbereiches für das zweite Medium (10, 9) aufweist.

5. Wärmetauscher (1; 32) gemäß einem der vorangegangenen Ansprüche, bei dem das Führungsblech (28) eine Profilierung (4, 31) aufweist.

6. Wärmetauscher (1; 32) gemäß Anspruch 5, bei dem die Profilierung (4, 31) in Form von einer Mehrzahl von länglichen Erhebungen ausgebildet ist, wobei die Mehrzahl von Erhebungen derart auf dem Führungsblech (28) angeordnet ist, dass eine meanderförmige Führung für das zweite Medium (9, 10) um mehrere Rohre (14; 15; 16; 17) ermöglicht wird.

7. Wärmetauscher (1; 32) gemäß Anspruch 5 der 6, bei dem das Führungbiech (28) eine Profilierung (4, 31) in Form einer Mehrzahl von Ausbuchtungen aufweist, wobei das Führungsblech zu mindestens einem weiteren Führungsblech mit einer Profilierung in Form einer Mehrzahl von Ausbuchtungen benachbart angeordnet ist, wobei die Ausbuchtungen der Profilierung des Führungsbleches rückseitig in die Ausbuchtungen der Profilierung des weiteren Führungsblechs eingreifen.

8. Wärmetauscher (1; 32) gemäß Anspruch 5 oder 6, bei dem das Führungsblech (28) zu mindestens einem weiteren Führungsblech mit einer Profilierung (4, 31) benachbart angeordnet ist, wobei die Profilierung des Führungsblechs und die Profilierung des weiteren Führungsblechs die gleiche Struktur aufweisen und in eine gleiche Erhebungsrichtung weisen, und Wobei das weitere Führungsblech um 180° in Bezug auf eine Normale zum Führungsblech gedreht ist.

9. Wärmetauscher (1; 32) gemäß Anspruch 5 oder 6, bei dem das Führungsblech (28) zu mindestens einem weiteren Führungsblech mit einer Profilierung (4, 31) benachbart angeordnet ist, wobei die Profilierung des Führungsblechs und die Profilierung des weiteren Führungsblechs einander zugewandt sind.

10. Wärmetauscher (1; 32) gemäß einem der vorangegangenen Ansprüche, bei dem das mindestens eine Führungsblech (28) im Bereich der Durchführungen des Rohres (14; 15; 16; 17) uneben ist.

## Claims

1. A heat exchanger (1; 32) for exchanging heat between two media (9, 10) in a vehicle, wherein the heat exchanger has the following features:
a plurality of double-walled tubes (14; 15; 16; 17) for guiding a first medium (9, 10) of a first temperature, **characterised in that** a thermoelectric material (12) is disposed between an inner wall of the double-walled tube and an outer wall of the double-walled tube or on an inner wall of the double-walled tube; and with a plurality of guide sheets (28) connected to the double-walled tubes for guiding a second medium (9, 10) of a second temperature, wherein the guide sheets are designed to guide the second medium to the outer walls of the double-walled tube to enable the exchange of heat between the first medium and the second medium.

2. The heat exchanger (1; 32) according to claim 1, wherein a guide sheet (28) has a plurality of recesses (29), and the double-walled tubes (14; 15; 16; 17) are accommodated by the recesses.

3. The heat exchanger (1; 32) according to one of the preceding claims, wherein at least one further, in particular double-walled, tube (14; 15; 16; 17) is disposed substantially parallel to the tube in a common first plane, and at least one third, in particular double-walled, tube is disposed in a second plane which is parallel to the first plane, wherein the third tube is disposed in the second plane in a position in which a passage is formed between the tube and the further tube in the first plane.

4. The heat exchanger (1; 32) according to one of the preceding claims, wherein the inner wall forms a guide channel for the first medium (9, 10), wherein the inner wall furthermore has protrusions (4) in the guide channel, and/or the outer wall furthermore has raised structures (4) in the direction of a flow area for the second medium (10, 9).

5. The heat exchanger (1; 32) according to one of the preceding claims, wherein the guide sheet (28) has a profiling (4, 31).

6. The heat exchanger (1; 32) according to claim 5, wherein the profiling (4, 31) is designed in the form of a plurality of elongate raised structures, wherein the plurality of raised structures is disposed on the guide sheet (28) in such a way that a meandering guidance for the second medium (9, 10) around multiple tubes (14; 15; 16; 17) is enabled.

7. The heat exchanger (1; 32) according to claim 5 or 6, wherein the guide sheet (28) has a profiling (4, 31) in the form of a plurality of protrusions, wherein the guide sheet is disposed adjacent to at least one further guide sheet having a profiling in the form of a plurality of protrusions, wherein the protrusions of the profiling of the guide sheet engage on the rear side with the protrusions of the profiling of the further guide sheet.

8. The heat exchanger (1; 32) according to claim 5 or 6, wherein the guide sheet (28) is disposed adjacent to at least one further guide sheet having a profiling (4, 31), wherein the profiling of the guide sheet and the profiling of the further guide sheet have the same structure and point in the same raising direction, and wherein the further guide sheet is rotated through 180° with respect to a normal to the guide sheet.

9. The heat exchanger (1; 32) according to claim 5 or 6, wherein the guide sheet (28) is disposed adjacent to at least one further guide sheet having a profiling (4, 31), wherein the profiling of the guide sheet and the profiling of the further guide sheet face towards each other.

10. The heat exchanger (1; 32) according to one of the preceding claims, wherein the at least one guide sheet (28) is uneven in the area of the passages in the tube (14; 15; 16; 17).

## Revendications

1. Echangeur de chaleur (1 ; 32) servant à l'échange de chaleur entre deux milieux (9, 10) dans un véhicule, où l'échangeur de chaleur présente les caractéristiques suivantes :
une pluralité de tubes à double paroi (14 ; 15 ; 16 ; 17) servant au guidage d'un premier milieu (9, 10) à une première température, **caractérisé en ce qu'**un matériau thermoélectrique (12) est disposé entre une paroi intérieure du tube à double paroi et une paroi extérieure du tube à double paroi, ou bien sur une paroi intérieure du tube à double paroi ; et avec une pluralité de tôles de guidage (28) assemblées avec les tubes à double paroi et servant au guidage d'un deuxième milieu (9, 10) à une deuxième température, où les tôles de guidage sont configurées, pour acheminer le deuxième milieu jusqu'aux parois extérieures des tubes à double paroi, pour rendre possible l'échange de chaleur entre le premier et le second milieu.

2. Echangeur de chaleur (1 ; 32) selon la revendication 1, dans lequel une tôle de guidage (28) présente une pluralité d'évidements (29), et les tubes à double paroi (14 ; 15 ; 16 ; 17) sont logés dans les évidements.

3. Echangeur de chaleur (1 ; 32) selon l'une ou l'autre des revendications précédentes, dans lequel au moins un autre tube (14 ; 15 ; 16 ; 17), en particulier à double paroi, est disposé pratiquement de façon parallèle au tube dans un premier plan commun, et au moins un troisième tube, en particulier à double paroi, est disposé dans un deuxième plan parallèle au premier plan, où le troisième tube est disposé, dans le deuxième plan, dans une position sur laquelle est formé, dans le premier plan, un passage entre le tube et l'autre tube.

4. Echangeur de chaleur (1 ; 32) selon l'une quelconque des revendications précédentes, dans lequel la paroi intérieure forme un conduit de guidage pour le premier milieu (9, 10), où la paroi intérieure présente en outre des parties bombées (4) dans le conduit de guidage, et / ou la paroi extérieure présente en outre des parties en saillie (4) en direction d'une zone de flux pour le deuxième milieu (10, 9).

5. Echangeur de chaleur (1 ; 32) selon l'une quelconque des revendications précédentes, dans lequel la tôle de guidage (28) présente un profilage (4, 31).

6. Echangeur de chaleur (1 ; 32) selon la revendication 5, dans lequel le profilage (4, 31) est configuré sous la forme d'une pluralité de parties allongées en saillie, où la pluralité de parties en saillie est disposée sur la tôle de guidage (28), de manière telle qu'un guidage en forme de méandres pour le deuxième milieu (9, 10) soit rendu possible autour de plusieurs tubes (14 ; 15 ; 16 ; 17).

7. Echangeur de chaleur (1 ; 32) selon la revendication 5 ou 6, dans lequel la tôle de guidage (28) présente un profilage (4, 31) sous la forme d'une pluralité de parties bombées, où la tôle de guidage est disposée en étant adjacente à au moins une autre tôle de guidage ayant un profilage sous la forme d'une pluralité de parties bombées, où les parties bombées du profilage de la tôle de guidage viennent en prise, sur la face arrière, dans les parties bombées du profilage de l'autre tôle de guidage.

8. Echangeur de chaleur (1 ; 32) selon la revendication 5 ou 6, dans lequel la tôle de guidage (28) est disposée en étant adjacente à au moins une autre tôle de guidage ayant un profilage (4, 31), où le profilage de la tôle de guidage et le profilage de l'autre tôle de guidage présentent la même structure et pointent dans une même direction d'élévation, et où l'autre tôle de guidage est tournée de 180° par rapport à une normale à la tôle de guidage.

9. Echangeur de chaleur (1 ; 32) selon la revendication 5 ou 6, dans lequel la tôle de guidage (28) est disposée en étant adjacente à au moins une autre tôle de guidage ayant un profilage (4, 31), où le profilage de la tôle de guidage et le profilage de l'autre tôle de guidage sont tournés l'un vers l'autre.

10. Echangeur de chaleur (1 ; 32) selon l'une quelconque des revendications précédentes, dans lequel la tôle de guidage (28) au moins au nombre de un n'est pas plane dans la zone des passages du tube (14 ; 15 ; 16 ; 17).
